(19) Europäisches Patentamt
European Patent Office
Office européen des brevets

(11) Publication number: **0 400 645 A1**

(12) **EUROPEAN PATENT APPLICATION**

(21) Application number: **90110365.5**

(51) Int. Cl.⁵: **H05K 13/04**

(22) Date of filing: **31.05.90**

(30) Priority: **31.05.89 JP 138622/89**

(43) Date of publication of application: **05.12.90 Bulletin 90/49**

(84) Designated Contracting States: **DE FR GB IT SE**

(71) Applicant: **SANYO ELECTRIC CO., LTD.**
**2-18, Keihan-hondori**
**Moriguchi-shi Osaka(JP)**

(72) Inventor: **Oyama, Kazuyoshi**
**446-2, Kamishibutarecho**
**Ashikaga-shi, Tochigi-ken(JP)**
Inventor: **Katsuta, Shigeo**
**1523, Ohaza-Sakata, Ohizumimachi**
**Ohra-gun, Gunma-ken(JP)**
Inventor: **Tsuruta, Shigeru**
**801-3, Ohaza-Shimokoizumi, Ohizumimachi**
**Ohra-gun, Gunma-ken(JP)**
Inventor: **Shimizu, Yoshio**
**38-3, Nishitakanecho**
**Tatebayashi-shi, Gunma-ken(JP)**
Inventor: **Koiwai, Minoru**
**57-1, Ohaza-Sumiyoshi, Ohizumimachi**
**Ohra-gun, Gunma-ken(JP)**
Inventor: **Imai, Masami**
**1273, Kubotacho, Ashikaga-shi**
**Tochigi-ken(JP)**

(74) Representative: **Glawe, Delfs, Moll & Partner**
**Patentanwälte**
**Postfach 26 01 62**
**D-8000 München 26(DE)**

(54) **Parts feed apparatus.**

(57) The present invention discloses a parts feed apparatus in which a plurality of plates for receiving parts of the same type are prepared in correspondence to plural types of parts, a stocker for receiving plural stages of plates and drawing means for drawing the plates from the stocker are relatively vertically moved by elevator means, and thereafter the plates having parts types to be removed received therein are drawn by the drawing means to feed the parts. The parts feed apparatus comprises memory means for storing parts type information and parts remaining number information every plate, and control means for controlling the elevator means so that a plate is drawn by the drawing means, said plate being smallest in parts remaining number among a plurality of plates for receiving parts of the same type as the parts type to be removed next in accordance with the informations stored in the memory means.

FIG. 1

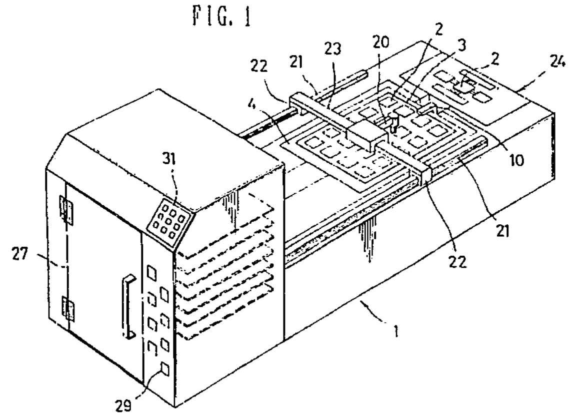


EP 0 400 645 A1

# PARTS FEED APPARATUS

## 2. BACKGROUND OF THE INVENTION

### (1) Field of the Invention

The present invention relates to a parts feed apparatus in which a plurality of plates for receiving the same type of parts is prepared so as to correspond to plural types of parts, a stocker for receiving plural stages of plates and draw-out means for drawing the plates from the stocker are relatively moved up and down by elevator means, and thereafter, the plates having parts of types to be removed received therein are drawn out by said draw-out means to feed parts.

### (2) Description of the Prior Art

Generally, in apparatus for automatically mounting electronic parts disclosed in U.S. Patent Nos. 4,653,664, 4,747,198, etc., there is known a parts feed apparatus in which electronic parts are received in a receiving tape and fed so that the parts can be attracted by attraction nozzles.

However, when electronic parts, for example, such as IC whose lead projects externally of the body, are received into a receiving tape, the lead becomes bended during handling. Therefore, a feed apparatus wherein parts are received into a tray has been put to practical use (See Japanese Patent Disclosure (Kokai) No. 61-280,700, etc.).

In the above-described parts feed apparatus which uses a tray, only the same parts are handled in the same stocker, and the apparatus is not suitable for handling a variety of parts. Therefore, a parts feed apparatus capable of handling a great meany variety of parts may be contemplated. Generally, when trays for receiving parts of the same type are received in plural stages of plates, plates for removing the parts are selected by assigning stage numbers.

However, in the aforementioned prior art, the stage number is assigned in connection with the type of article, and therefore, the assignment of the stage number was cumbersome.

Because of this, there is contemplated a method for assigning types of parts. In this case, it is necessary to determine plates of what stage number is selected. Plates charged-trays received therein become increased in dependency of the way of selection. As a result, there occurs such disadvantages that trays without parts irregularly and continuously appear, and trays have to be often replaced; that if there are many charged-trays when the charged-trays are replaced in a case where stages are replaced, a receiving space need be increased; and that management for remaining number of parts are cumbersome.

A further disadvantage is that a moving length of an elevator is long in dependency of the way of selection, thus taking a long period of time of operation.

## 3. OBJECT OF THE INVENTION

It is therefore an object of the present invention to minimize charged-trays, minimize a moving distance of an elevator, and improve the way of handling by an operator.

According to Claim 1, control means controls an elevator means so that a plate whose parts remaining number is minimal out of a plurality of plates for receiving the same type of parts as parts to be removed next is positioned at a draw-out position in accordance with informations stored in a memory means.

According to Claim 2, control means controls an elevator means so that a plate whose stage receiving order is early out of a plurality of plates for receiving the same 'type of parts as parts to be removed next is positioned at a draw-out position in accordance with informations stored in a memory means.

According to Claim 3, selection means selects one type of program from plural kinds of programs stored in a memory means, and control means controls an elevator means in accordance with the program selected by the selection means.

According to Claim 4, control means control said elevator means so that in a case where there are present a plurality of plates for receiving the same type of parts as parts to be removed next, a plate whose parts receiving order stored in said memory means is earliest is drawn out by a draw-out means.

According to Claim 5, control means controls an elevator means so that a plate positioned in a shortest moving distance from a removing position out of a plurality of plates for receiving the same type of parts as parts to be removed next is positioned at a draw-out position in accordance with informations stored in a memory means.

According to Claim 6, a difference in stage stored in a first comparison memory based on informations stored in a memory means and a difference in stage stored in a second comparison memory based on informations stored in said memory means are compared by a comparison means, and control means controls an elevator means so that a plate of the parts type to be removed next in a shortest moving distance is positioned at a draw-out position in accordance with which are a smaller difference in stage compared by the comparison means and the comparison memory with a small difference in stage stored therein.

According to Claim 7, control means controls an elevator means so that a table is moved to a plate receiving stage whose moving distance from a present table position to a parts feed level position is shortest among plurality of plate receiving stages for receiving the same type of parts as the parts type to be removed next in accordance with informations stored in a memory means.

According to Claim 8, control means controls an elevator means so that a table is moved to a plate receiving stage whose moving distance of the table in order of the present table position - the position from which the desired plate is drawn out - the parts feed level position - the aforesaid position from which the desired plate is drawn out is shortest among a plurality of plate receiving stages for receiving the same type of parts as the parts type to be removed next in accordance with informations stored in a memory means.

## 4. BRIEF DESCRIPTION OF THE DRAWINGS

FIGS. 1 to 9 show a first embodiment of the present invention;

FIG. 1 is a perspective view of a parts feed apparatus according to the present invention;

FIG. 2 is a side view showing essential parts of the apparatus;

FIG. 3 is a view showing a mechanism of an elevator;

FIG. 4 is a side view showing a construction of a tray draw-out pawl;

FIG. 5 is a control block diagram of the present invention;

FIG. 6 is a view showing a flow chart of a sequence 1 mode;

FIG. 7 is a view showing a flow chart of a sequence 2 mode;

FIG. 8 is a view showing a flow chart of a tact mode;

FIG. 9 is a view showing an example of informations on stage number, type of article, and remaining number of works stored in RAM;

FIGS. 10 to 41 show a second embodiment of the present invention;

FIG. 10 is a perspective view of a parts feed apparatus;

FIG. 11 is a side view of a parts feed apparatus and a parts mounter;

FIG. 12 is an enlarged side view of a draw-out table, a stocker and the like;

FIG. 13 is a side view showing the drawing operation of plates;

FIG. 14 is a control block diagram;

FIGS. 15, 29, 32, 34 and 36 show data of RAM;

FIGS. 16 and 17 are flow charts of sequence modes;

FIGS. 18 and 19 are flow charts of parts removing operations;

FIGS. 20 to 22 are side views showing the drawing operation of plates;

FIGS. 23 to 28 are flow charts of tact modes;

FIGS. 30 and 31 are flow charts of early in- and out modes;

FIG. 3 is a flow chart for replacement of order data;

FIG. 35 is a flow chart for operation of replacement and detection of plates and operation of storing order data; and

FIGS. 37 to 41 are flow charts of a second tact mode.

## 5. DETAILED DESCRIPTION OF THE INVENTION

First, a first embodiment of the present invention will be described with reference to the drawings. Referring to FIGS. 1, 2 and 3, reference numeral 1 designates a parts feed apparatus to which the present invention is applied; 2 chip parts (hereinafter referred to as parts) mounted on a printed circuit board; and 3 a tray on which parts 2 are placed and received.

Reference numeral 4 designates a plate adapted to lock the tray 3 to place the latter thereon, the plate being formed in its end with an upwardly rising element as shown in FIG. 4. Reference numeral 5 designates a vertically movable elevator provided with a multi-stage (10 stages in the present embodiment) of plate receiving grooves 6 so that the plates 4 may be placed thereon. Reference numeral 7 designates a pair of screws for vertically moving an elevator which extend through a nut portion 8 provided on the side of the elevator 5, the screws being driven and rotated by an elevator drive unit 9 to move the elevator 5 upward and downward.

Reference numeral 10 designates a tray draw-out pawl mounted on a belt 11 and driven by a traverse drive unit 13 shown in FIG. 5 through said belt 11 and sprockets 12 and 12, the pawl capable of being reciprocated through a notch in the surface along which is slidably moved the plate 4 located in a removal position. The draw-out pawl 10 is composed of a fixed element 15 and a rotatable element 17 which is rotatable about a support shaft 16 with respect to the fixed element 15. The rotatably element 17 is urged in a direction of closing the draw-out pawl 10 by means of a spring 18 having one end secured to the fixed element 15. A cylinder 19 causes the rotatable element 17 to be rotated clockwise against the biasing force of the spring 18. During the operation of drawing the plate 4, the cylinder 4 is in an attracted state. The rotatable element is rotated counterclockwise by the biasing force of the spring 18 and engaged in the rising element formed in the end of the plate 4. Upon completion of reception of the tray 3 into the elevator 5, the cylinder 19 projects and the plate 4 is released from the draw-out pawl 10.

Reference numeral 20 designates a P&P (Pick and Place) suction head which is slidably moved along a guide shaft 23 laterally mounted between sliders 22 and 22 which slidably move on guide rails 21 and 21 whereby the suction head may be moved in X-Y direction. The suction head 20 attracts the parts 2 from the tray 3 on the plate 4 drawn-out by the draw-out pawl 10 to place the parts 2 on a removed chip positioning unit 24. Reference numeral 27 designates an elevator door opened and closed when the trays 3 stacked on the elevator 5 are replaced; and 28 a door open/close sensor for stopping upward and downward movement of the elevator 5 and operation of the draw-out pawl 10 when the door 27 is opened to detect open- and closing of the door 27 so that when the door 27 is closed, the operation may be begun.

Reference numeral 29 designates an illumination type tray-set confirmation switch provided so as to correspond to each of the trays 3 within the elevator 5. The switch 29 flickers when the remaining number of the parts 2 is less than a set level of quantity, is turned on when the remaining number is "0", and is turned off by being depressed after the tray 3 has been replaced.

Reference numeral 31 designates a mode change-over switch which selects a sequence 1 mode, a sequence 2 mode and a tact mode in connection with the vertical movement of the elevator in the case where there are a plurality of elevator stages with the same type of parts received therein.

Reference numeral 32 designates a vacuum chuck (capable of being moved in X, Y and Z directions) mounted on a main mounting device 33. The vacuum chuck 32 vacuum-adsorbs the parts 2 positioned by the chip positioning unit 24 to mount the parts on the printed circuit board.

In FIG. 5, reference numeral 35 designates ROM which stores a plurality of programs (a sequence 1 mode, a sequence 2 mode and a tact mode) what plate is positioned at a removal position by what procedure in the case where a plurality of plates for receiving the same type of parts are received. Reference numeral 36 designates CPU, which performs control in connection with the feed of chip parts 2 in accordance with various informations.

Reference numeral 37 designates RAM which stores informations on the stage number of the elevator 5, the type of chip parts 2 every stage number, the remaining number of chip parts 2 every stage number (hereinafter referred to remaining number of works). Reference numeral 38 designates a remaining number comparison memory which stores a remaining number of works in the sequence 1 mode. Reference numeral 39 designates a destination memory which stores a stage number moving in the sequence 1 mode.

Reference numeral 40 designates a stage comparison memory 1 and 41 denotes a stage comparison memory 2, which in the tact mode, store a number of difference in stage between a stage which stops at a removal position at present (hereinafter referred to a present stop stage) and a stage in which is received the type to be removed next requested by the main mounting device 33 (hereinafter referred to as a requested type). In the stage of the elevator 5, the lowest stage has a number 1, and the higher stage the number increases. The uppermost stage may have a number 1. Reference 42 designates a check stage counter for storing a stage number for checking the type of chip parts 2 and a remaining number of works. Reference numeral 43 designates CRT for displaying various informations on an image plane. Reference numeral 44 designates an interface which is connected to the elevator drive unit 9, the traverse drive unit 13, the cylinder 19, the positioning drive unit 45, the vacuum chuck drive unit 46, the P&P drive unit 47, etc.

The operation of the apparatus constructed as described above will be described hereinafter.

## I Sequence 1 mode

First, a description is made of the case where the mode change-over switch 31 is switched to the sequence 1 mode, with reference to a flow chart of FIG. 6. In this mode, empty trays are produced from the stage which has the same type and is less in the remaining number of works. However, in the stage having the same remaining number of works, a stage having a smaller stage number takes precedence.

When the parts 2 of Type 7 is requested by the main mounting device 33, the CPU 36 causes the remaining number comparison memory 38 to store a number obtained by adding "1" to the maximum number work number per stage, the destination memory 39 to store "0", and sets the check stage counter 42 to "1". Since the content in the check stage counter 42 is "1", the type of a stage number 1 is checked from data of FIG. 9 stored in the RAM 37. Since the type of a stage being checked (hereinafter referred to as a check stage) is Type 7 which coincides with the requested type, the remaining number comparison memory 38 and the check stage, i.e., the work remaining number of the stage number 1 are compared.

Since the work remaining number "60" is less than a number stored in the remaining number comparison memory 38, "1" of the check stage number is stored in the destination memory 39, and "60" which is the work remaining number of the check stage is stored in the remaining number comparison memory 38.

Next, the check stage counter 42 is caused to step by "1" to assume "2". The type of the stage number 2 is Type 1 and different from the requested type, and therefore, the check stage counter 42 is caused to step by "1" to assume "3". Since types up to the stage number 5 are different from the requested type, the check stage counter is caused to step by "1" similarly to the above so that the check stage counter 42 assumes "6".

Since the type of the stage number 6 is Type 7, data stored in the remaining number comparison memory 38 and the work remaining number of the stage number 6 are compared. Since the work remaining number of the stage number 6 is "30" which is smaller than "60" stored in the remaining number comparison memory 38, "6" which is a stage number is stored in place of "1" in the destination memory 39, and "30" is stored in place of "60" in the remaining number comparison memory 38. The content of the check stage counter 42 is caused to step by "1" to assume "7".

When the check stage counter 42 is further caused to step to assume "8", the remaining number comparison memory 38 and the work remaining number are compared in a manner similar to that as previously mentioned since the type of parts of the check stage is Type 7 which is the same as the requested type, and since the work remaining number "20" is smaller, a stage number 8 is stored in the destination memory 39, and "20" is stored in the remaining number comparison memory 38.

In the aforementioned process, in the case where the check stage is the requested type, check is made if the work remaining number of the check stage is "0". If the number is "0", the check stage counter 42 is stepped by "1" and a next stage number is checked. When assurance is made that the work remaining number is not "0", data of the remaining comparison memory 38 and the work remaining number of the check stage are compared as mentioned above. That is, when the work remaining number is "0", this check stage is ignored.

Thereafter, the CPU 36 performs checking of stages, while stepping the check stage counter 42 similarly to the above, till all 10 stages are checked, and the check stage counter 42 is then set to "11". At this time, a stage number of the requested type whose work remaining number is smallest is stored in the destination memory 39.

The CPU 36 reads that the check stage counter 42 is "11" and then assures that data of the destination memory 39 is not "0". If the present stop stage is the same as the destination memory 39, the elevator drive unit 9 is left undriven. If the present stop stage is a stage number 4, the present stop stage number is subtracted from data of the destination memory since "4" of the present stop stage is small as compared with "8" of the destination memory 39. The elevator 5 is moved down by four stage portions from the calculated result "4", and the elevator 5 is positioned at a position of a stage number 8 which is smallest in the work remaining number among the requested type 7.

Then, the plate 4 at a position of the stage number 8 is drawn out of the plate receiving groove 6 by the draw-out pawl 10. The P&P suction head 20 adsorbs the parts 2 placed on the tray 3 on the plate 4 to transfer the parts 2 to the chip positioning unit 24. When the chip positioning unit 24 positions the parts 2 by means of the positioning drive unit 45, the vacuum chuck 32 driven by the vacuum chuck drive unit 46 adsorbs the parts 2 to mount the latter in position on the printed circuit board.

The above-described operation is continuously carried out. When one of the plates 4 becomes empty, the tray-set confirmation switch 29 is turned on. As a result, an operator replaces the plate 4 with one filled with parts 2. When the operator opens the elevator door 27 for such replacement, the door open- and close sensor 28 detects this, and the CPU 36 stops the elevator drive unit 9. When the operator depresses the tray-set confirmation switch 29 after the tray 3 has been replaced, the switch 29 is turned off. The work remaining number of a corresponding stage number of RAM 37 assumes a full quantity.

## II. Sequence 2 mode

In the following, a description will be made of the case where the mode change-over switch 31 is switched to the sequence 2 mode with reference to a flow chart of FIG. 7.

In this mode, an empty tray is produced from a small stage number among stages in which the same type of parts 2 are received.

It is assumed that the parts 2 of Type 7 is requested by the main mounting device 33 similarly to the case of the sequence 1 mode. The check stage counter 42 is first set to "1" to check the type of a stage number 1 from data of FIG. 9 stored in the RAM 37. Since the type of the stage number 1 is Type 7 and of the same as the requested type, and when assurance is made of that a work remaining number of the stage number 1 is not "0", checking of data stored in the RAM 37 is here terminated.

If the type of the stage number 1 should not be the requested type, the check stage counter 42 is stepped by "1" to assume "2", and the type of the stage number 2 is checked. Thereafter, such checking operation is repeated till the same type as the requested Type 7 is found. Even if the type is not the requested type but the work remaining number is "0", the check stage counter 42 is stepped by "1" and the checking operation is repeated. Since now the requested type is received in the stage number 1 and the work remaining number is not "0", checking is made if the present stop stage is the stage number 1 as the check stage. If the present stop stage is the stage number 1, the elevator 5 is not driven but the plate 4 is drawn out by the draw-out pawl 10.

When the present stop stage is the stage number 4, the check stage is small, and therefore, the check stage number is subtracted from the present stop stage. The elevator 5 is moved up by three stage portions as the calculated result and stops at a position from which the stage number 1 is drawn out by the draw-out pawl 10.

Thereafter, the parts 2 are mounted on the printed circuit board in a manner similar to the description of the sequence 1 mode. It is to be noted that types may be checked in order of larger stage numbers to move the plate 4 of a stage number which first receives the requested type to a removal position.

III. Tact mode

A description will be made of the case where the mode change-over switch 31 is switched to the tact mode with reference to a flow chart of FIG. 8. In this mode, the elevator 5 is controlled so that the elevator moves to a stage of requested type nearest to the present stop stage.

The CPU first reads the type of the present stop stage to check if the type is the same as the requested type. If the type of the present stop stage is the same as the requested type and the work remaining number of the present stop stage is not "0", the elevator 5 is not driven and the plate 4 is drawn out by the draw-out pawl 10. In the case where the the type of the present stop stage is different from the requested type or even if the type of the present stop stage is the same as the requested type the work remaining number is "0", a value obtained by subtracting "1" from the present stop stage number is stored in the check stage counter 42.

It is assumed that the present stop stage is a number 4 and the requested type is Type 7, the requested type is different from the type of the present stop stage as shown in FIG. 9, "3" is stored in the check stage counter 42. Checking is made if the check stage number 3 is the requested type. Since the check stage number 3 is different from the requested Type 7, the check stage counter 42 is further subtracted by "1" and "2" is stored therein. Since the stage number 26 is also different from Type 7, a stage number 1 is then checked. Since the type of the stage number 1 is Type 7 of the requested type, assurance is made that the work remaining number of the stage number 1 is not "0" and thereafter the CPU 36 stores "3", which is the calculated result obtained by subtracting the check stage number from the present stop stage, into the stage comparison memory 1 (40), and "1", which is the calculated result obtained by adding "1" to the present stop stage, is stored in the check stage counter 42.

If the work remaining number of the stage number 1 as the requested type should be "0", the CPU 36 subtracts data of the check stage counter 42 by "1". As the result of subtraction, the check stage counter 42 is "0", and the requested type is not received in a stage lower than the present stop stage. Therefore, the CPU 36 causes the stage comparison memory 1 (40) to store "0" and the check stage counter 42 to store "5" obtained by adding "1" to the present stop stage in order to check stages higher than the present stop stage.

The CPU 36 checks if the type of the stage number 5 is identical with the requested type in accordance with "5" of the check stage counter 42 but is different from data shown in FIG. 9 and therefore the check stage counter 42 is stepped by "1" and "6" is stored. The stage number 6 stores the requested Type 7 whereby assurance is made of that the work remaining number of the stage number 6 is not "0". "2", which is the calculated result obtained by subtracting the present stop stage number from the check stage, is stored in the stage comparison memory 2 (41).

If the work remaining number of the stage number 6 should be "0", the check stage counter 42 is stepped by "1" to check the type. This checking operation of the type is repeated till the stage number with the requested type stored therein is found. In the case where even if the requested type is present or not present, the work remaining number is "0" and the data of the check stage counter 42 is "11", the requested type is not received in a stage higher than the present stop stage. Therefore, "0" is stored in the stage comparison memory 2 (41).

Thereafter, the CPU 36 controls the elevator drive unit 9 in accordance with the data of the stage comparison memory 1 (40) and the stage comparison memory 2 (41). In the case where data of the stage comparison memory 1 (40) is "0" and that of the stage comparison memory 2 (41) is "0", the requested type is not received in the parts feed apparatus 1. Therefore, the elevator drive unit 9 is not driven.

In the case where the stage comparison memory 1 (40 is "0" and the stage comparison memory 2 (41) is not "0", the elevator 5 is moved down in accordance with the stage comparison memory 2 (41). In the case where the stage comparison memory 1 (40) is not "0" and the stage comparison memory 2 (41) is "0", the elevator 5 is moved up in accord ance with the stage comparison memory 1 (40). In the case where both data of the stage comparison memory 1 (40) and stage comparison memory 2 (41) are not "0", both the comparison memories are compared. If data of the stage comparison memory 1 (40) is smaller than the other or both the data are equal, the elevator 5 is moved up in accordance with the stage comparison memory 1 (40). If data of the stage comparison memory 2 is smaller than the other, the elevator 5 is moved down in accordance with the stage comparison memory 2 (41).

Since data of the stage comparison memory 1-(40) is "3" and that of the stage comparison memory 2 (41) is "2", the CPU 36 causes the elevator drive unit 9 to drive so that the elevator 5 is moved down by two stage portions.

How many stages distanced from the present stop stage up to the elevator stage of the request type nearest to upward and downward directions from the present stop stage are stored in the respective comparison memories. The CPU 36 compares the stage comparison memories with each other to thereby judge which stage is nearer, the upward or downward direction, and the elevator drive unit 9 is driven in accordance with the data stored in the near stage comparison memory. In the tact mode, it is to be noted that the elevator drive unit 9 may be controlled so that types of parts are checked in order of stage numbers, a difference in stage among the requested type, stage numbers of the same types and present stop stage and stage numbers therof are stored, and these differences are compared to find a stage number which is to be a minimum difference in stage so that the plate 4 having said stage number is positioned at a removal position.

A second embodiment of the present invention will be described with reference to the drawings.

In FIGS. 10 and 11, reference numeral 101 designates a parts feed apparatus for feeding electronic parts 103 (hereinafter referred to as parts) placed on a tray 102 to a parts mounting device 104.

The parts feed apparatus 101 will be described hereinafter.

Reference numeral 105 designates a stocker unit comprising a stocker 1(107) and a stocker 2-(108) on which 10 stages of plates 106 are stacked, respectively. Within the stocker 1 (107) and stocker 2 (108), the paltes 106 are received in the respective plate receiving stages.

One or more trays 102 are secured to and placed on the plate 106 in a positioned state. On the stocker unit 105 is mounted a safety door 109 which is opened and closed when an operator replaces the plate 106.

Reference numeral 111 designates an elevator unit, which draws out the plate 106 from the stocker unit 105 to upwardly move the plate to a parts removing unit 112. In the parts removing unit 112, the parts 103 placed on the tray 102 are removed and transferred to a transfer shuttle unit 113.

The elevator unit 111 will be described hereinbelow.

Reference numeral 114 designates a drawing table on which plates 106 drawn out of the stocker 107 are placed. A roundhead screw 117 rotated by an elevating motor 116 is engaged with a nut 115 mounted on the table 114. The drawing table 114 is guided by guides 118 and 118 and moved upward by the drive of the motor 116.

Reference numeral 119 designates a drawing table on which plates 106 drawn out of the stocker 2 (108) are placed. The table 119 is provided with the same mechanism with the elevating mechanism provided on the aforesaid table 114. Accordingly, two tables 114 and 119 can be moved up and down independently from each other.

As shown in FIG. 12, the drawing tables 114 and 119 have a draw-out pawl 120 mounted on a drawing belt 121. The belt 121 is extended between draw-out driven pulleys 122, 122 and 122 and a draw-out drive pulley 123. The draw-out pawl 120 is guided by two parallel draw-out guide shafts 125 and 125 by a draw-out motor 124.

The draw-out pawl 20 is composed of a push-back element 127 engaged with the end of the plate 106 to push back the plate 106, and a pull-out element 129 which rotates about a support shaft 128 provided on the push-back element 127, engages a rising portion at the end of the plate 106 and pulls out the plate 106.

On the drawing tables 114 and 119 are further mounted a vertically movable cylinder 132. The vertically movable cylinder 132 has a rod 133 which performs the function that the rod 133 is moved upward to push up the pull-out element 129 against the biasing force of a spring 135 in the case where the draw-out pawl 120 is in a draw-out position as shown in FIG. 13. When the rod 133 is moved downward, the pull-out element 129 is rotated downward by the biasing force of the spring 135 and the draw-out pawl 120 is closed.

Reference numeral 136 designates a plate detction sensor provided on the drawing tables 114 and 119. The plate detection sensor 136 comprises a reflective type photosensor to detect if the plate 106 is forced into a position capable of being engaged by the draw-out pawl 120 within the stocker 107 or stocker 108.

The parts removing unit 112 will be described hereinafter. In FIG. 10, reference numeral 139 designates a P&P head. Two suction nozzles 141 for attracting parts 103 from the tray 102 are independently mounted vertically movably by a drive source not shown. The P&P head 139 is mounted on a Y-axis belt 142, which is in turn extended between a drive pulley 144 mounted on a Y-axis motor 143 and a driven pulley 145. By the rotation of the Y-axis motor 143, the P&P head 139 is guided by a Y-guide rail 146 through the belt 142 for movement in a direction of Y. Reference numeral 147 designates an X-movable member to which are mounted the drive pulley 144, the driven pulley 145 and the Y guide rail 146, the X-movable member being mounted on the X-axis belt 148.

The X-axis belt 148 is extended between a drive pulley 150 mounted on an X-axis motor 149 and a driven pulley 151. By the rotation of the X-axis motor 149, the X-movable member 147 is guided by X-guide rails 152 and 152 for movement in a direction of X.

Accordingly, the P&P head 139 moves in XY direction on the drawing tables 114 and 119 moved upward to a position at which the parts 103 are removed. The parts 103 at a suitable position are attracted and removed by the suction nozzle 141 moved downward by the drive source not shown. The P&P head 139 further moves to transfer the parts 103 to a parts tray 153 of the transfer shuttle unit 113. A height position of the tables 114 and 119 at which the parts 103 are removed by the suction nozzle 141 as a parts feed height position is hereinafter referred to as "parts removing position".

In the transfer shuttle unit 113, the parts tray 153 with the parts 103 substantially horizontally placed thereon is reciprocated by a cylinder drive source not shown between a position at which the parts 103 attracted by the suction nozzle 141 are placed and a parts attraction position of a mounting nozzle 155 of the parts mounting device 104. The parts tray 153 is capable of placing thereon the parts in number up to two received in the tray 102 by the attraction nozzle 141. These two parts 103 are placed at a position capable of attracting the parts by two mounting nozzles 155 at the same spacing as the mounting spacing of the suction nozzle 155.

An operating panel 156 has a plate supply switch 158 and the like, which is depressed by an operator, when the plate 106 has been replaced, to inform the CPU 157 of termination of replacement.

In FIG. 14, the CPU 157 controls the operation of the parts feed apparatus 101 in accordance with information of request for parts from the parts mounting device 104, information from various switches and sensors, stored information of RAM 159, and the like.

Reference numeral 160 designates ROM which stores programs related to operation of CPU 157 such as a plurality of programs as to in what procedure and which plate 106 are drawn out onto the drawing tables 114 and 119 in the case where a plurality of plates 106 receiving the same type of parts 103 are received in the stocker unit 105.

Reference numeral 162 designates an I.O interface.

Reference numeral 163 designates a mode change-over switch, which selects a sequence mode, a tact mode or an early in- and out mode in connection with the drawing operation of the plates 106 in the case where a plurality of plate receiving stages with the same type of parts 103 received therein are present in the stocker unit 105.

RAM 159 stores, for example, as shown in FIG. 15, informations concerning stage numbers of plate receiving stages, types of electronic parts 103 according to stage numbers, remaining numbers of the parts 103 according to stage numbers (hereinafter referred to as work remaining number), order data for storing an order number replaced previously by an operator among the same type of plates 106, etc. In the case where the plate 106 is projected on the side of the safety door 109 by the stocker unit 105 every stage number within the RAM 159, data "E" is stored in column P of FIG. 15.

With respect to the stage numbers of the plate receiving stages in the stocker unit 105, the lowest stage of the stocker 107 has a number 1; the higher stage the larger number; the lowest stage of the stocker 108 has a number 11; and the higher stage the larger number.

Reference numeral 164 designates a check stage counter which stores a stage number in order that CPU 157 checks the aforementioned data stored in RAM 159 according to stage numbers.

Reference numeral 165 designates a requested type memory R1 which stores the type of one parts 103 among two parts 103 and 103 requested by the mounting device 104. Reference numeral 166 designates a requested type memory R2 which stores the type of the other part.

It is to be noted that in the case where type of the parts 103 to be attracted is limited according to the kind of the mounting nozzles 155, the type of the parts 103 to be attracted by the corresponding mounting nozzle 155 of the mounting device 104 may be stored in the memory 1 (165) and memory R2 (166).

Reference numeral 167 designates a destination memory T1, which stores a stage number of the plate 106 in which the parts 103 of the type stored in the memory R1 (165) is received. Reference numeral 168 designates a destination memory T2 which stores a stage number of the plate 106 in which the parts 103 of the type stored in the memory R2 (166) is received. The tables 114 and 119 are to move to the plate receiving stages of the stage numbers stored in the memory T1 (167) and memory T2 (168).

Reference numeral 169 designates a destination memory T3 which stores a stage number of the type stored in the memory R1 (165), and reference numeral 170 designates a destination memory T4 which stores a stage number of type type stored in the memory R2 (166). In the tact 1 mode, the memory T1 (167) and memory T2 (168) store stage numbers of the plate receiving stages on the side of the stocker 1 (107), and the memory T3 (169) and memory T4 (170) store stage numbers of the plate receiving stages on the side of the stocker 108.

Reference numeral 171 designates a remaining number comparison memory W1 which stores a work remaining number of the type of the memory R1 (165) for comparison by those whose stage numbers are different, and reference numeral 172 designates a remaining number comparison memory W2 for storing a work remaining number of the type of the memory R2 (166).

Reference numeral 173 designates a checked memory F1 which stores if the type in the stocker 1 (107) has been checked, and reference numeral 174 designates a checked memory F2 which stores if the type in the stocker 2 (108) has been checked.

Reference numeral 175 designates a movement stage number comparison memory C1 for storing a movement stage number of the table 114 in the case where the parts 103 of the type of the memory R1 (165) are removed from the stocker 1 (107) side, and reference numeral 176 designates a movement stage number comparison memory C2 which stores a movement stage number in the case where the parts 103 of the memory R2 (166) are removed from the stocker 1 (107) side.

Reference numeral 177 designates a movement stage number comparison memory C3 for storing a movement stage number in the case where the parts 103 of the memory R 1 (165) are removed from the stocker 2 (108) side, and reference numeral 178 designates a movement stage number comparison memory C4 for storing a movement stage number in the case where the parts 103 of the memory R2 (166) are removed from the stocker 2 (108) side.

Reference numeral 180 designates an empty plate order data memory for storing order data of a plate receiving stage in which a work remaining number is "0" in the case where a work remaining number of one plate 106 is "0 (zero)" and the order data of the type is changed, and reference numeral 181 designates an empty plate type memory for storing the type of the parts 103 of said receiving stage.

Reference numeral 182 designates a type memory for storing the type of the receiving parts 103 of the plate 106 in order to set the order data of the receiving stage of the plate 106 after the plate 106 in which the work remaining number is "0" has been replaced with the plate 106 with the parts 103 received therein, and reference numeral 183 designates an order data comparision memory for compar ing the order data of each receiving stage in the aforesaid case.

The state of types of parts in the present stocker unit 105, the work remaining number and the like is as shown in FIG. 15, which information is stored in RAM 159.

The operation of the apparatus constructed as described above will be described hereinafter.

## I. Sequence mode

First, a description will be made of the case where the mode change-over switch 163 is switched to the sequence mode with reference to flow charts of FIGS. 16 and 17, respectively. In this mode, an empty tray is produced from a receiving stage of the same type and less work remaining number. In the receiving stage of the same work remaining number, a receiving stage with small stage number takes precedence.

It is assumed that first stop positions of the tables 114 and 119 are positions of plate receiving stages of a stage number 10 and a stage number 20 which are the uppermost stages, respectively.

When the parts mounting device 104 requests a type "11" and a type "25", the CPU 157 first clears the destination memory T1 (167) and memory T2 (168) to "0 (zero)", stores the type "11" in the requested type memory 165 and stores the type "25" in the memory R2 (166) in accordance with the flowcharts of FIGS. 16 and 17. The CPU 157 further stores numbers ("81" in the present embodiment) obtained by adding "1" to the maximum value of full parts number of all the plates 106 in the remaining number comparison memory W1 (171) and memory W2 (172), respectively.

Since the memory R1 (165) is not "0", the CPU 157 sets the check stage counter 164 to "1" to check if the type of the stage number 1 stored in the RAM 159 coincides with the requested type "11". The value of the check stage counter 164 is the stage number of the plate receiving stage for checking the data. The plate receiving stage for checking the data will be referred hereinafter to as the check stage.

The type of the check stage is "11" which compares the remaining number comparison memory W1 (171) with the check stage, that is, the work remaining number of the stage number 1 in order to coincide with the requested type.

Since a number stored in the remaining number comparison memory W1 (171) is smaller than the work remaining number "8", the CPU 157 stores a stage number "1" of the check stage in the destination memory T1 (167) and stores the work remaining number "8" of the check stage in the remaining number comparison memory W1 (171).

Next, the check stage counter 164 is stepped by "1" to assume "2". Since the type of the stage number 2 is not "11", the check stage counter 164 is stepped to assume "3".

When the counter 164 assumes "5", the CPU 157 compares data "8" of the comparison memory W1 (171) with the work remaining number "11" of the check stage since the type of the check stage is the requested type. Since the data of the memory W1 (171) is smaller, the CPU 157 sets the counter 164 to "6". The above-described operation is repeated. In the stage number 13, the type coincides with the requested type, and the work remaining number is "4" which is smaller than data "8" of the comparison memory W1 (171), and therefore, "13" is stored in the destination memory T1 (167) and "4" is stored in the comparison memory W1 (171).

Similar checking operation is further repeated. When stage numbers up to 20 are checked, the counter 164 assumes "21". The CPU 157 makes sure of that data of the destination memory T1 (167) is not "0" to start the operation shown in a flow chart of FIG. 18 in which parts 103 are fed from the plate 106 of the plate receiving stage indicated by the memory T1 (167).

The plate receiving stage of the stage number 13 indicated by the data "13" of the destination memory T1 (167) is within the stocker 2 (108). In the present stocker 2 (108), the table 119 remains stopped in a state where the plate 106 is not placed but is at the position of the stage number 20. Then, the motor 116 is driven so as to move down the drawing table 119 by seven stages obtained by subtracting data "13" of the destination memory T1 (167) from "20". The state where the tables 114 and 119 with the plate not placed thereon after the plate 106 has been received in the plate receiving stage in which the plate 106 should be received after removal of the parts 103 is called the standby state after removal, and the plate receiving stage in which the tables 114 and 119 in the standby state after removal is hereinafter called the present stop stage.

In the present embodiment, the present stop stage is the plate receiving stage having the plate 106 received therein.

Upon rotation of the roundhead screw 117, the table 119 is guided by the guides 118 and 118 through the unit 115 and moved down, and then stops at the plate receiving stage of the stage number 13.

Then, upon rotation of the drawing motor 124, the draw-out pawl 120 moves toward the stocker 2 (108).

When the draw-out pawl 120 once stops at a position of the original point before the stocker 2 (108), the rod 133 is moved upward by actuation of the cylinder 132 to swing and push up the draw-out element 129 about the support shaft 128 against the spring 135 as shown in FIG. 20. The motor 124 further rotates, and the draw-out pawl 120 moves in its open state and stops at the draw-out position as shown in FIG. 13. Then, the rod 133 is moved down by the cylinder 132, and the pawl 120 is closed by the biasing force of the spring 135 to hold the rising portion of the end of the plate 106 as shown in FIG. 21. Subsequently, the motor 124 rotates, and the plate 106 is drawn out as shown in FIG. 22 by the pawl 120 which moves in a direction of moving away from the stocker 2 (108).

Thereafter, the motor 116 is rotated according to the command of the CPU 157, and the table 119 moves upward to the parts removing position.

Upon rotation of the X-axis motor 149, the X-movable member 147 is moved along the X-guide rail 152 through the drive pulley 150, the driven pulley 151 and the X-axis belt 148. Upon rotation of the Y-axis motor 143, the P&P head 139 is moved along the Y-guide rail 146 through the drive pulley 144, the driven pulley 145 and the Y-axis belt 142. The suction nozzle 141 stops at a position of the parts 103 to be drawn out next on the plate 106 to attract the parts 103. The work remaining number of the stage number 13 within the RAM 159 is subtracted by "1" to assume "3".

The CPU 157 causes downward movement of the table 119 to start simultaneously with the removing operation of the requested type "11" as described above, and thereafter decides if the type "25" of the requested type memory R2 (167) is removed from which plate receiving stage in a manner similar to the case of the requested type "11" in accordance with the flow charts of FIGS. 16 and 17. As the result, "2" is stored in the destination memory T2 (168). In the present stocker 1 (107), the table 114 stops, which is at a position of the stage number 10, and the motor 116 is rotated so as to move down the drawing table 114 by eight stage portions obtained by subtracting data "2" of the destination memory T2 (168) from "10". The table 114 stops at the plate receiving stage of the stage number 2, and the plate 106 is drawn out in a manner as previously mentioned. At the parts removing position, the parts 103 are removed by the other suction nozzle 141, and the work remaining number of the stage number 2 within the RAM 159 is subtracted by "1" to assume "3".

II. Tact Mode

A description will be made of the operation in which the mode change-over switch 163 is switched to the tact mode with reference to flow charts of FIGS. 23 to 28.

In this mode, in the case where there is a plurality of stages of plates 106 for receiving the same types so as to feed parts 103 at the shortest time from a time when type request is made by the mounting device 104, the plates 106 are drawn at which the distance wherein the tables 114 and 119 draw the plates 106 from the present stop stage and moves to the parts removing position is shortest.

After the parts 103 have been removed, the tables 114 and 119 are moved down to the plate receiving stage to receive the plates 106. Then, the tables 114 and 119 stop at that position to assume the standby state after removal.

At present, data in the RAM 159 are as shown in FIG. 29. The present stop stage of the table 114 has the stage number 2, and the present stop stage of the table 119 has the stage number 19.

When the mounting device 104 requests the type "11" and type "80" as request types, the type "11" and type "80" are stored in the requested type memory R1 (165) and requested type memory R2 (166), respectively, in accordance with flow charts of FIGS. 23 and 28.

Since the table 114 is in the standby state after removal, the CUP 157 causes the check stage counter 164 to store the stage number 2 of the present stop stage of the drawing table 114 of the stocker 1 (107). After assurance of the fact that the check stage counter 164 is not "11", assurance is made if the type of the stage number 2 as the check stage is identical with the type "11" of the requested type memory R7 (165) according to the data in the RAM 159 shown in FIG. 29.

Since the type of the check stage is "25" which is different from type "11", the CPU 157 causes the counter 164 to step by "1" to assume "3".

Checking of the stage number 3 is carried out in a manner similar to the case of the stage number 2. However, since it is different from the type "11", the counter 164 assumes "4". When the counter 164 has "5", the type of the stage number 5 is "11". Therefore, the CPU confirms that the work remaining number is not "0" to cause the movement stage number comparison memory 175 to store a stage number "8" obtained by adding "3" as the stage number from the present stop stage "2" to the check stage "5" to a stage number "5" from the check stage "5" to the parts removing position, and to cause the destination memory T1 (167) to store "5". In this case, with respect to the type "11", the movement stage number "'8" in the case where the parts 103 are removed from the plate 106 of the stage number 5 is the shortest movement stage number since the plate receiving stage of the stage number 5 is between the present stop stage (stage number 2) and the parts removing position.

Next, "2" of the present stop stage is again stored in the check stage counter 164, and checking of the type "80" of the requested type memory R2 (166) is carried out in a manner similar to the case of the aforementioned re- requested type memory R1 (165). Assurance can be made of the type "80" in the stage number 3, and the work remaining number is not "0". Therefore, the movement stage number "8" is stored in the comparison memory C2 (176), and "3" stored in the memory T2 (168). Since the plate receiving stage of this stage number is also present between the present stop stage and the parts removing position, the movement stage number is the shortest movement stage number.

"7" is stored in the checked memory F1 (173).

Next, with respect to the stocker 108, stage numbers of the plate receiving stages for receiving types "11", and "80" are checked in a manner similar to the case of the stocker 107.

First, after assurance has been made of the fact that the present stop stage of the stocker 2 (108) is "19", "19" is stored in the check stage counter 164 and the counter 164 is not "21", checking is made if the type of the check stage is "11" of the requested type memory R1 (165). Since the stage number 19 is not "11" and the stage number 20 is not "11", the counter 164 is stepped to "21".

Since the counter 164 is "21", the CPU 157 causes the counter 164 to assume "18" ontained by subtracting "7" from the present stop stage. Since the counter 164 is not "0", the CPU 157 checks the type of the stage number 18. However, since the type is different from the type "11", the counter 164 is subtracted by "1" to assume "17", and the type is checked. In this manner, the counter 164 is subtracted by "1", and checking of the type is continued so that the counter 164 assumes "13" and the type of the stage number 13 is "11". Therefore, assurance is made of the fact that the work remaining number is not "0". The movement stage number "14" obtained by adding a stage number "6" from the present stop stage to the check stage to a stage number "8" from the check stage to the parts removing position is stored in the comparison memory C3 (177), and "13" is stored in the memory T3 (169). In this case, since the plate receiving stage of the type "11" is not present between the present stop stage (stage number 19) and the parts removing position, the movement stage number is shortest in that the plate 106 is drawn out from the stage number 13 which is below the present stop stage and nearest to the parts removing position.

Subsequently, checking of the plate receiving stage of the type "80" of the stocker 2 (108) is carried out to assure that the type "80" is received in the stage number 18. Therefore, "4" as the movement stage number is stored in the comparison memory C4 (178), and "18" is stored in the memory T4 (170). "1" is stored in the checked memory F2 (174). In this manner, stored in each of the destination memories is a stage number whose movement stage num ber is least in the same types within the same stocker. Thereafter, the CPU 157 makes sure of the fact that data of the memory R1 (165) is not identical with that of the memory R2 (166), that is, two parts 103 of the same type are not requested, and further makes sure of the fact that all of data of the memory C1 (175), memory C2 (176), memory C3 (177) and memory C4 (178) are not "0", that is, plate receiving stages of respective types are present in the stocker 1 (107) and stocker 2 (108), respectively. Then, decision is made from which stocker 1 (107) or stocker 2 (108) the type "11" and type "80" are removed in accordance with the flow chart.

Since data "8" of the memory C1 (175) is larger than "4" of the memory C4 (178) and data "8" of the memory C2 (176) is smaller than data "14" of the memory C3 (177), the CPU 157 compares the memory C1 (175) with the memory C3 (177). When the memory C1 (175) is smaller than the other, the CPU 157 removes the type "11" of the requested type memory R1 (165) from the stage number 5 of the plate receiving stage of the stage number 5 of the stocker 1 (107) in accordance with the data stored in the destination memory T1 (168) to decide the removal of the type "80" from the plate receiving stage of the stage number 18 of the stocker 2 (108) in accordance with the data stored in the destinaion memory T4 (170).

Such a decision as described above is made for the reasons as follows. Both the tables 114 and 119 are in the standby state after removal. The case where the type "11" is removed from the stage number 5 and the type "80" is removed from the stage number 18 is compared with the case where the type "11" is removed from the stage number 13 and the type "80" is removed from the stage number 3. In the case of the former, one whose movement stage number from the present stop stage to the parts removing position is long is short, that is, a time till arrival of the table arriving at the parts removing position later is short, and the parts 103 and 103 are more early placed on the parts tray 153.

After the aforesaid decision has been made, the CPU 157 sends a request OK signal notifying the mounting device 104 that a type request may be made and awaits for next type request.

The motors 116 and 116 are then rotated, and the tables 114 and 119 simultaneously starts to be moved.

The table 114 stops at the plate receiving stage of the stage number 5 to draw the plate 106, and the table 119 stops at the plate receiving stage of the state number 18 to draw the plate 106, in accordance with the flow chart of FIG. 18, the tables 114 and 119 being moved upward to the parts removing position. Since the movement distance of the table 119 is short and arrives at the parts removing position earlier than the table 114, the P&P head 139 moves to a position of the parts 103 to be removed next of the table 119, and the parts 103 is attracted by one suction nozzle 141 for removal of the parts 103. Then, the work remaining number of the stage number 18 is subtracted by "1" to assume "23".

Thereafter, when the table 114 arrives at the parts removing position, the P&P head 139 moves toward the table 114, and the suction nozzle 141 attracts the parts 103 to be removed next to remove the parts 103. The work remaining number of the stage number 5 is subtracted by "1" to assume "10".

After the parts 103 have been removed, the tables 114 and 119 are moved down, and then stop at the plate receiving stages adapated to receive the plates 106 and 106. The plates 106 and 106 are received by the movement of the draw-out pawl 120.

On the other hand, when the parts 103 and 103 are attracted by the suction nozzles 141 and 141, the P&P head 139 moves to the parts tray 153, an the parts 103 and 103 are transferred onto the parts tray 153. And, the parts tray 153 moves, and the mounting nozzles 155 and 155 attract the parts 103 and 103 on the parts tray 153 to mount the parts 103 and 103 on the printed circuit board not shown.

III. Early in- and out mode

The operation of the early in- and out mode will be described hereinafter.

The mode change-over switch 163 is switched to the early in- and out mode, and the parts feed operation is carried out in accordance with flow charts of FIGS. 30 and 31.

In this mode, in the case where the plates 106 of the same type are received in a plurality of plate receiving stages, parts 103 are removed from a plate which has been first replaced, that is, a plate which has been received in the stocker unit 105 for a longest period of time. When the mode change-over switch 163 is switched to the early in- and out mode, the content of data stored in the RAM 159 is as shown in FIG. 32. It is assumed that when the mode change-over switch 163 is switched, the present stop stage of the table 114 has a stage number 52, and the present stop stage of the table 119 has a stage number 18. When the mounting device 104 requests parts 103 and 103 of types "25" and "6", the CPU 157 clears the destination memory T1 (167) and memory T2 (168) to assume "0" to store the type "25" in the memory R1 (165) and the type "6" in the memory R2 (166). Assurance is made of the fact that both the tables 114 and 119 are in the standby state after removal and that the content of the memory R1 (165) is not "0" to set the check stage counter 164 to "1". Then, the CPU 157 checks if the type of the stage number 1 coincides with the requested type "25", and since they are not in coincidence, the counter 164 is stpped by "1" to assume "2". When the CPU 157 checks the type of the stage number 2, it coincides with the requested type, and therefore, the CPU 157 then checks if order data is "1". Since the order data of the stage number 2 is "1", the CPU 157 stores "2" of the counter 164 in the destination memory T1 (167). Since the memory R1 (165) does not coincide with the memory R2 (166), movement of the table 114 from the plate receiving stage of the stage number 1 is allowed to start in order to draw the plate 106 from the plate receiving stage of the stage number 2.

Thereafter, because data of the memory R2 (166) is not "0", the CPU 157 checks in which plate receiving stage the type "6" stored in the memory R2 (166) is received, in a manner similar to the case of the memory R1 (165).

In this case, when the check stage counter 164 assumes "4", the type "6" is found. Since order data is not "1", the counter 164 is stepped by "1", and the checking operation is further continued. When the counter 164 assumes "15", the CPU 157 confirms that the type is "6" and the order data is "1", and therefore, "15" is stored in the memory T2 (168).

Since the plate receiving stage indicated by the memory T2 (168) is not present in the stocker 1 (107) having the plate receiving stage indicated by the memory T1 (167), the CPU 157 starts movement of the table 119 being stopped at the stage number 19 toward the plate receiving stage of the stage number 15. Thereafter, the CPU delivers a request OK signal to the parts mounting device 104.

When the tables 114 and 119 move to the plate receiving stages indicated by the memory T1 (167) and memory T2 (168), respectively, the plates 106 and 106 are drawn and placed on the tables 114 and 119. The parts 103 and 103 to be removed next are attracted by the suction nozzles 141 and 141 from the plates 106 and 106 of the respective tables at the parts removing position in a manner similar to the case of the aforementioned other modes and transferred to the parts tray 153, after which the parts are mounted on the printed circuit board in a manner previously mentioned. At that time, when the parts 103 of the type "25" are removed from the table 114, the work remaining number of the stage number 2 stored in the RAM 159 is subtracted by "1" to assume "2". When the parts 103 of the type "6" are removed from the table 119, the work remaining number of the stage number 15 is subtracted by "1" to assume "20".

When the mounting device 104 requests two parts 103 of the type "25", the CPU 157 sets the memory T1 (167) and memory T2 (168) to "0" and stores "25" in the memory R1 (165) and memory R2 (166), respectively.

The CPU 157 confirms that the tables 114 and 119 are in the standby stage after removal and that data of the memory R1 (165) is not "0". The CPU 157 sets the counter 164 to "1" to start checking of types. Thereafter, the counter 164 is stepped to "2", in a manner similar to that as mentioned above, then the type is "25" and the order data is "1". Therefore, "2" is stored in the memory T1 (167). The CPU 157 then checks if data of the memory R1 (165) is the same as that of the memory R2 (166). Since they are the same, checking is made if the work remaining number is two or more. Since the work remaining number is "2", it is moved to the plate receiving stage of the stage number 2 shown in the flow chart of FIG. 19 to draw the plate 106. The operation of continuously removing two parts 103 from the plate 106 by the suction nozzles 141 and 141 is started to deliver a request OK signal. Then, the table 114 is in the standby state after removal at the plate receiving stage of the stage number 2 indicated by the destination memory T1 (167), and therefore, the plate 106 is immediately drawn out and placed on the table 114. The table 114 is moved upward to the parts removing position, and one suction nozzle 141 attracts the parts 103. Then, the work remaining number of the stage number 2 is sub tracted by "1" to assume "1". Thereafter, the other suction nozzle 141 attracts next parts 103 on the table 114, and the work remaining number of the stage number 2 is subtracted by "1" to assume "0".

Thereafter, the table 114 is moved down to the plate receiving stage of the stage number 2, and the plate 106 is received in the plate receiving stage and projected through a predetermined length toward the safety door (109) by movement of the draw-out pawl 120. And, data "E" is stored in the stage number 2 of RAM 159.

The parts 103 and 103 attracted by the suction nozzles 141 and 141 are mounted on the printed circuit board by the suction nozzles 155 and 155 in a manner similarly as mentioned above.

However, when during the aforesaid operation, the second parts 103 is attracted and the work remaining number of the stage number 2 is "0", replacement of the order data of the type "25" is carried out in accordance with a flow chart of FIG. 33.

First, the order data "1" of the stage number 2 for which the work remaining number is "0" is stored in an empty plate order data memory 180, and the order data of the stage number 2 is "0".

Next, the type "25" for which the work maining number is "0" is stored in an empty plate type memory 181, and "1" is stored in the check stage counter "164".

Checking is made if the type of the stage number 1 coincides with the data of the empty plate type memory 181. Since they are not in concidence, the counter 164 is set to "2".

Since the order data of the stage number is "0" , which is larger than "1" of the empty order data memory 180, the counter 164 is set to "3". In this manner, when the counter 164 is "9", the type is "25" and the order data of the stage number 9 is "2", which is larger than data "1" of the empty plate order data memory 180, and therefore, the order data of the stage number 9 is subtracted by "1" to assume "1".

This operation is carried out with respect to all stage numbers till the counter 164 assumes "2", and all order data of the type "25" are subtracted by "1", and each data in the RAM 159 is as shown in FIG. 34.

The replacing operation of the order data shown in the flow chart of FIG. 33 is carried out not only in the case of the early in- and out mode but also in any other case where the work remaining number of any stage number is "0".

In any mode, when the work remaining number of any stage number is "0", the plate 106 received in the plate receiving stage of said stage number is projected from the stocker unit 105 toward the safety door 109 by the drawout pawl 20, and "E" is stored in the stage number of the RAM 159. When the plate 106 is projected toward the safety door 109, an operator finds that the projected plate 106 is empty. The said plate is replaced with a plate 106 filled with parts 103 to be received in the plate receiving stage.

At present, since the plates 106 and 106 of the plate receiving stages of the stage number 2 and stage number 12 are projected as shown by data of FIG. 34, an operator replaces the plate 106 filled with the parts 103 of the type "25" with the plate 106 of the stage number 2, and replaces the plate 106 filled with the parts 103 of the type "1" with the plate 106 of the stage number 12. Thereafter, when the operator depresses a plate supply switch 158, the CPU 157 detects that replacement of the plate 106 has been finished to start an operation for detecting that a plate 106 in which plate receiving stage has been replaced (hereinafter referred to as the replacement detecting operation).

The replacement detecting operation and a storing operation of order data after plate replacement will be described hereinafter with reference to a flow chart of FIG. 35.

When the plate supply switch 158 is depressed, both the tables 114 and 119 assume the standby state after removal, and thereafter, the CPU 157 first checks if data "E" is stored in the stage number 1 in the RAM 159.

Since the data "E" is not stored in the stage number 1, and when the stage number 2 is then checked, the data "E" is stored, and therefore, the table 114 is moved to the plate receiving stage of the stage number 2. Then, the plate detection sensor 136 is turned ON to thereby detect that the plate 106 has been replaced. Thereafter, data "E" is erased, and the work remaining number is set to full "35".

The CPU 157 stores the type "25" of the stage number 2 in a type memory 182, and an order data comparison memory 183 is set to "0". Then, the check stage counter 164 is set to "1" to check if the type of the stage number 1 coincides with the type "25" of the type memory "182". Since they are not in coincidence, the counter 164 is stepped by "1" to assume "2". Since the type of the stage number 2 coincides with the type memory 182, the comparison memory 182 is compared with the order data. Since the order data is not large, the counter 164 is stepped by "1" to assume "3".

When the counter 164 assumes "9", the type of the check stage is "25", the order data is "1" which is larger than the comparison memory 182. Therefore, the counter 164 is stepped after "1" has been stored in the comparison memory 183. When the counter 164 assumes "20", "4" is stored in the comparison memory 183. When the counter 164 is stepped to "21", value "5" obtained by stepping data "4" of the comparison memory by "1" is stored in the order data of the stage number 2 for which plate 106 is detected by the plate detection sensor 136.

Next, the CPU 157 checks presence or absence of the data "E" with respect to the stage number 3 and thereafter checks presence or absence of data "E" with respect to stage numbers to the stage number 20. Since the data "E" is not present, the plate replacement detecting operation and the order-data storing operation associated with the detecting operation are terminated to deliver a request OK signal to the mounting device 104. At this time, data in the RAM 159 is as shown in FIG. 36.

In the case where the supply switch 158 is depressed even if the mode change-over switch 163 is switched to any mode, the replacement detecting operation and the order data storing operation similar to those mentioned above in accordance with the flow chart of FIG. 36 are carried out.

It is to be noted that as the sequence 2 mode in the second embodiment, parts 103 can be fed from the plate 106 received in the plate receiving stage having the smallest stage number (or the largest stage number) among the plates 106 on which the parts 103 of the same type are placed in a manner similar to the case of the sequence 2 mode in the first embodiment.

Furthermore, in the tact mode of the second embodiment, when any of tables assumes the standby state after removal as shown in the flow charts of FIGS. 23 and 28, checking operation of the types of the types of the plate receiving stage in the corresponding stocker is immediately carried out. In the case where the plate 106 for receiving the requested type is present, the removing operation of the parts 103 shown in the flow chart of FIG. 18 or FIG. 19 is immediately carried out to reduce time for which two tables 114 and 119 remain stopped. Particularly, if a type request is made before one table does not terminate the removing operation of parts and when the other table assumes the standby state after removal after movement, the first table is not yet in the standby state after removal, the table in the standby state after removal again starts the removing operation to eliminate waste of time.

Moreover, while in the tact mode of the second embodiment, movement stage numbers of the table from the present stop stage to the parts removing position via the check stage have been stored in the movement stage number comparison memories C1 (175) to C4 (178), it is contemplated that as the second tact mode, movement stage numbers from the present stop stage of the table back to the check stage via the check stage and the parts removing position are stored in the memories C1 (175) to C4 (178).

Flow charts of the operation of the second tact mode are shown in FIGS. 37 to 41.

The second tact mode performs the removal of parts 103 from plates 106 in which time from the start of the movement of the table for removing the parts 103 to the assumption of the standby state after removal is shortest.

In the case where the check stage for receiving the requested type is present between the present stop stage and the parts removing position, there is a difference between the tact mode and the second tact mode in that in the former, the movement stage number is the same whereas in the latter, the movement stage number reduces for the plate receiving stage closer to the parts removing position.

There is a further difference between the tact mode and the second tact mode as shown in the flow chart in decision as to which table should be moved in the case where data which is not "0" are stored in all of the memories C1 (175) to C4 (178). In the second tact mode, one table moves to the plate receiving stage of the comparison memory whose movement stage number is smallest while the other table moves to the plate 106 for receiving the parts 103 different therefrom. The second tact mode is applied to the case of effecting early movement of the table with respect to next request for type. The tact mode in the flow charts of FIGS. 23 to 28 is applied to the case of effecting early feed of parts 103 with respect to the present request for type.

Furthermore, it is to be noted that even in the case of construction as in the first embodiment, order data as in the second embodiment is stored every stage number of RAM, and the plate receiving stage of the destination is determined in accordance with flow charts similar to FIGS. 30 and 31 to effect the operation of the early in- and out mode. In this case, replacement of order data in the case where the work remaining number is "0" is carried out in accordance with a flow chart similar to FIG. 33. Storing of the order data after the plate has been replaced can be realized by replacing "Plate detection sensor - ON" with "Tray-set confirmation switch - ON" in the flow chart of FIG. 35 and in accordance with the thereafter flow charts.

Moreover, while in the early in- and out mode, the order data is assigned with "1" every the same type, it is to be noted that order data of the plate 106 first replaced among all the plates 106 in th stocker unit 105 is assigned with "1" irrespective of the types and thereafter numbers are assigned in order of replacement so that decision as to which plate receiving stage is drawn is in accordance with the stage of the smallest order data in the same type.

With the arrangement as described above, according to the present invention, charged trays can be minimized. The moving distance of the elevator can be reduced as short as possible. Parts received early can be first fed, and therefore, it is possible to eliminate a phenomenon that parts remains in the stocker for a long period of time. In addition, how to handle by an operator can be enhanced.

## Claims

1. A parts feed apparatus in which a plurality of plates for receiving parts of the same type are prepared in correspondence to plural types of parts, a stocker for receiving plural stages of plates and drawing means for drawing the plates from said stocker are relatively vertically moved by elevator means, and thereafter the plates having parts types to be removed received therein are drawn by said drawing means to feed the parts, characterized by memory means for storing parts type information and parts remaining number information every plate, and control means for controlling said elevator means so that a plate is drawn by said drawing means, said plate being smallest in parts remaining number among a plurality of plates for receiving parts of the same type as the parts type to be removed next in accordance with the informations stored in said memory means.

2. A parts feed apparatus in which a plurality of plates for receiving parts of the same type are prepared in correspondence to plural types of parts, a stocker for receiving plural stages of plates and drawing means for drawing the plates from said stocker are relatively vertically moved by elevator means, and thereafter the plates having parts types to be removed received therein are drawn by said drawing means to feed the parts, characterized by memory means for storing stage receiving order information, parts type information and parts remaining number information every plate, and control means for controlling said elevator means so that a plate is located at a drawing position, said plate having an early stage receiving order among a plurality of plates for receiving parts of the same type as the parts type to be removed next in accordance with the informations stored in said memory means.

3. A parts feed apparatus in which a plurality of plates for receiving parts of the same type are prepared in correspondence to plural types of parts, a stocker for receiving plural stages of plates and drawing means for drawing the plates from said stocker are relatively vertically moved by elevator means, and thereafter the plates having parts types to be removed received therein are drawn by said drawing means to feed the parts, characterized by memory means for storing a plurality of kinds of programs as to which plate is located at a removing position by what procedure in the case where a pluality of plates for receiving parts of the same type are received, selection means for selecting one kind of program out of the plurality of kinds of programs stored in said memory means, and control means for controlling said elevator means in accordance with the program selected by said selection means.

4. A parts feed apparatus in which a plurality of plates for receiving parts of the same type are prepared in correspondence to plural types of parts, a stocker for receiving plural stages of plates and drawing means for drawing the plates from said stocker are relatively vertically moved by elevator means, and thereafter the plates having parts types to be removed received therein are drawn by said drawing means to feed the parts, characterized by memory means for storing stage receiving order information and parts type information every plate and a plate whose parts receiving order is earliest among a plurality of plates for receiving the same type, and control means for controlling said elevator means so that in the case where a plurality of plates for receiving parts of the same type as the parts type to be removed next are present, the earliest plate stored in said memory means is drawn by said drawing means.

5. A parts feed apparatus in which a plurality of plates for receiving parts of the same type are prepared in correspondence to plural types of parts, said plates being received in plural stages, a plate having the parts type to be removed next can be vertically moved to a removing position by an elevator mechanism, and the plate located at said removing position is drawn by a drawing device to feed the parts, characterized by memory means for storing stage receiving order information, parts type information and parts remaining number information every plate, and control means for controlling said elevator means so that a plate is located at a drawing position, said plate being located at a shortest movement distance from a removing position among a plurality of plates for receiving the parts of the same type as the parts type to be removed next in accordance with the informations stored in said memory means.

6. A parts feed apparatus in which a plurality of plates for receiving parts of the same type are prepared in correspondence to plural types of parts, said plates being received in plural stages, a plate having the parts type to be removed next can be vertically moved to a removing position by an elevator mechanism, and the plate located at said removing position is drawn by a drawing device to feed the parts, characterized by memory means for storing stage receiving order information, parts type information and parts remaining number information every plate, a first comparison memory for storing a difference in stage with respect to a removing position of a plate, said plate being located upwardly of a removing position and being at a shortest movement distance from the removing position among a plurality of plates for receiving parts of the same type as the parts type to be removed next in accordance with the informations stored in said memory means, a second comparison memory for storing a difference in stage with respect to a removing position of a plate, said plate being located downwardly of the removing position and being at a shortest movement distance from the removing position among a plurality of plates for receiving parts of the same type as the parts type to be removed next in accordance with data stored in said memory means, and control means for controlling said elevator means so that a plate is located at a drawing position, said plate having less difference in stage as the result of comparison by said comparison means.

7. A parts feed apparatus in which a plurality of plates for receiving parts of the same type are prepared in correspondence to plural types of parts, said plate is drawn by drawing means onto a table vertically moved by elevator means with respect to a stocker from the stocker for receiving said plates in a plurality of plate receiving stages, and thereafter said table is moved to a parts feed height position to feed the parts, characterized by memory means for storing stage receiving order informationand parts type information for parts received every plate receiving stage of said stocker, and control means for controlling said elevator means so that said table is moved to a plate receiving stage, said plate receiving stage being shortest in movement distance from the present table position to a parts feed height position among a plurality of palte receiving stages for receiving parts of the same type as the parts type to be removed next in accodance with the informations stored in said memory means.

8. A parts feed apparatus in which a plurality of plates for receiving parts of the same type are prepared in correspondence to plural types of parts, said plate is drawn by drawing means onto a table vertically moved by elevator means with respect to a stocker from the stocker for receiving said plates in a plurality of plate receiving stages, and thereafter said table is moved to a parts feed height position to feed the parts, characterized by memory means for storing stage receiving order informationand parts type information for parts received every plate receiving stage of said stocker, and control means for controlling said elevator means so that a plate is moved to said table, said plate being shortest in movement distance of the table from the present table position back to a position from which the desired plate is again drawn via the position from which the desired plate is drawn and a parts feed position among a plurality of plate receiving stages for receiving parts of the same type as the parts type to be removed next in accordance with the informations stored in said memory means.

FIG. 1

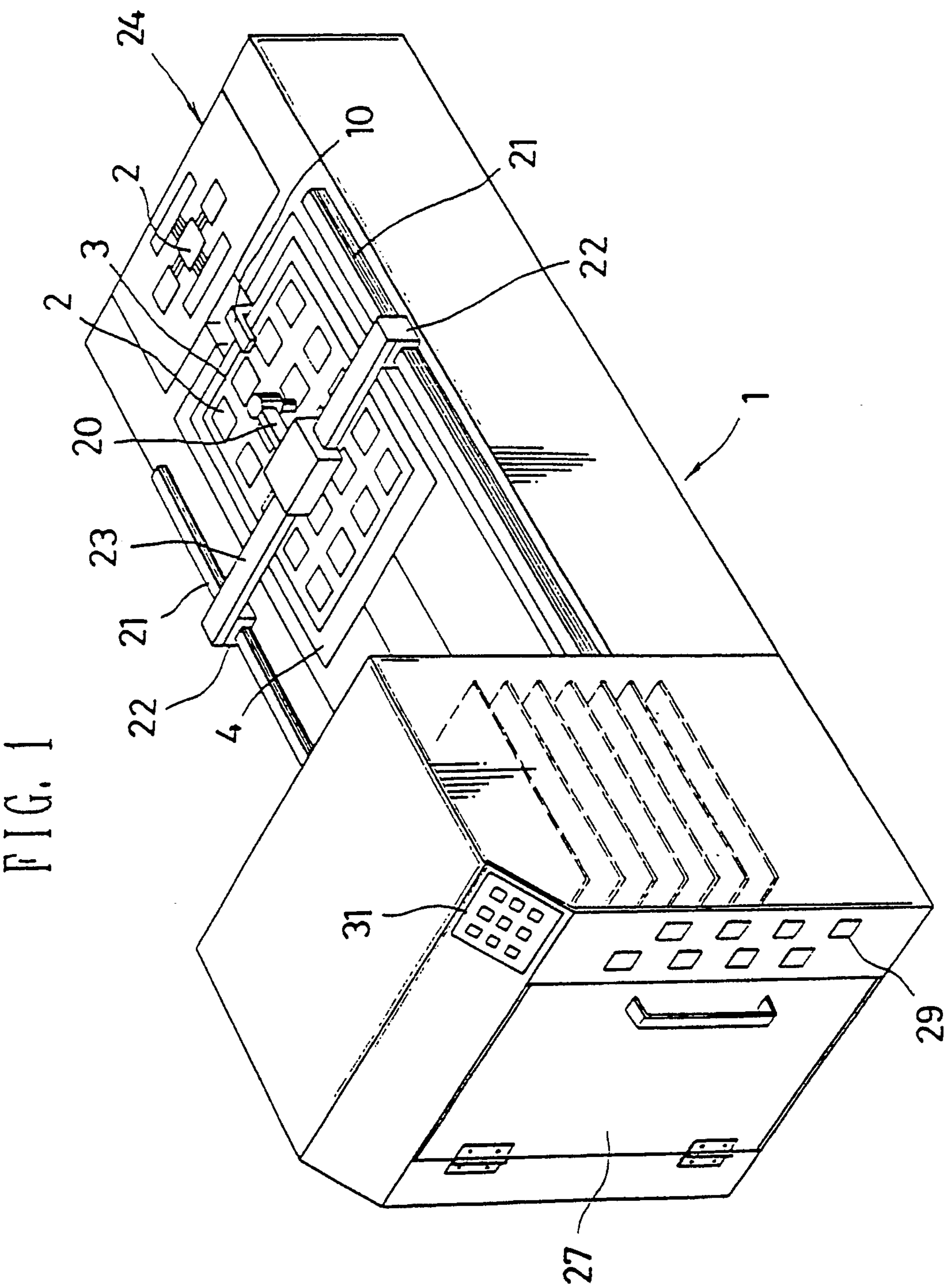

FIG. 2

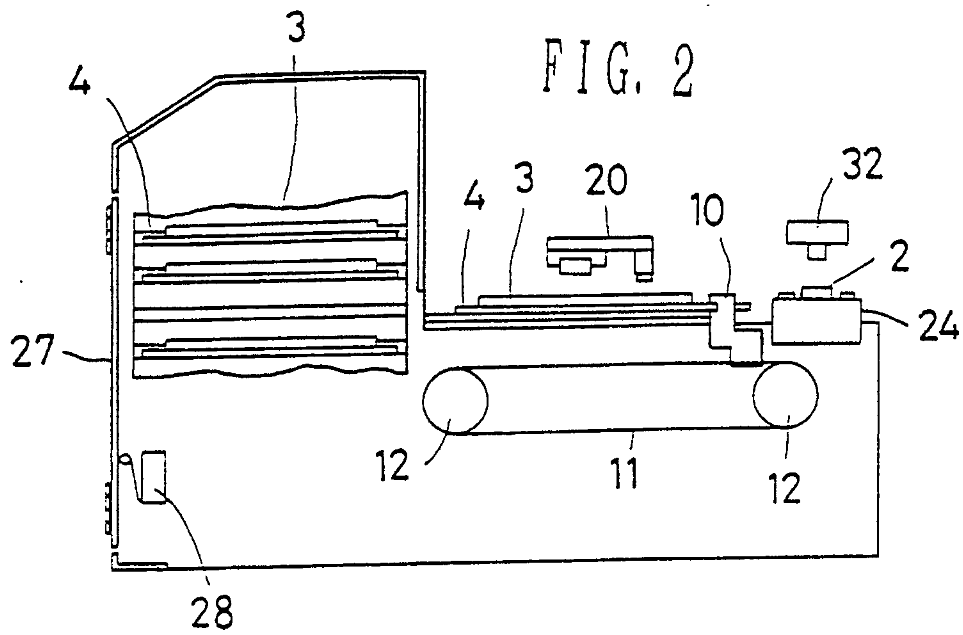


FIG. 3

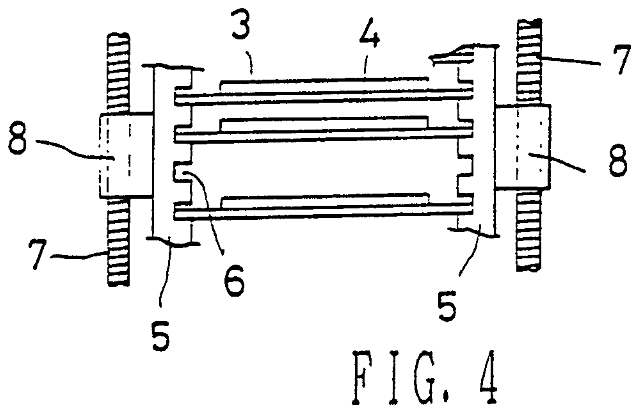


FIG. 4

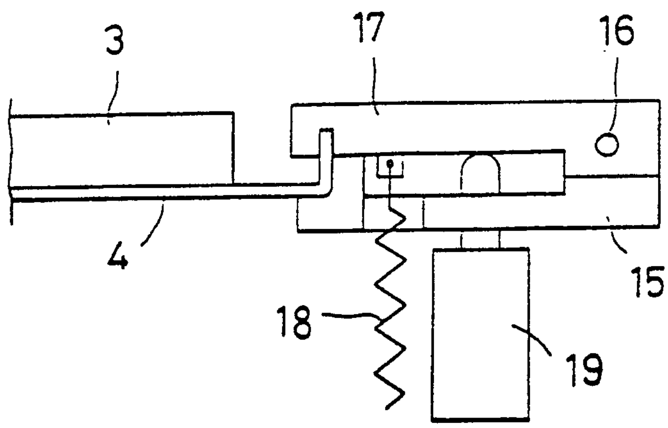

FIG. 5

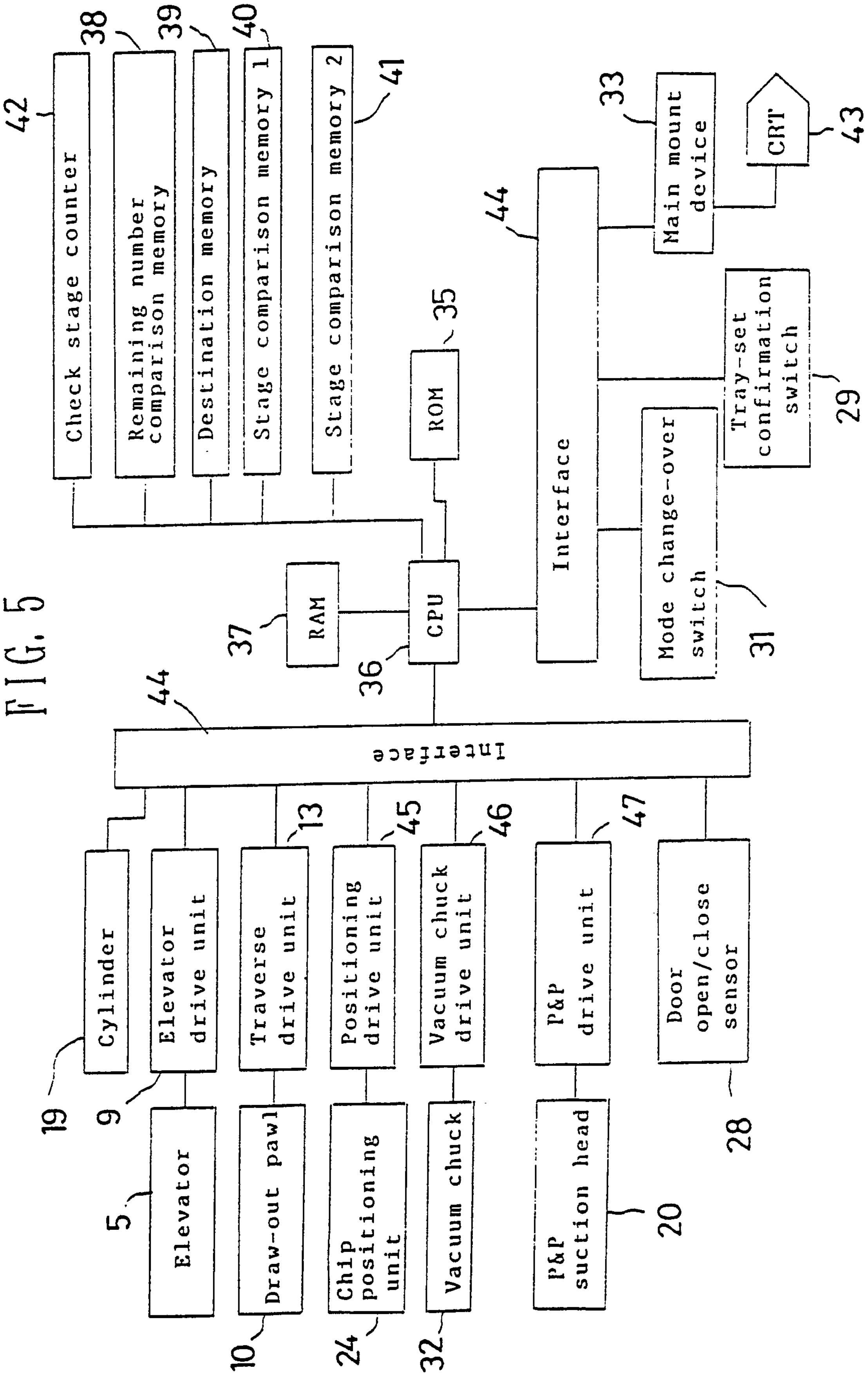
Check stage counter
Remaining number comparison memory
Destination memory
Stage comparison memory 1
Stage comparison memory 2
ROM
RAM
CPU
Interface
Main mount device
CRT
Tray-set confirmation switch
Mode change-over switch
Interface
Cylinder
Elevator drive unit
Traverse drive unit
Positioning drive unit
Vacuum chuck drive unit
P&P drive unit
Door open/close sensor
Elevator
Draw-out pawl
Chip positioning unit
Vacuum chuck
P&P suction head
42
38
39
40
41
33
43
44
35
29
31
37
36
44
13
45
46
47
19
9
28
5
20
10
24
32

FIG. 6

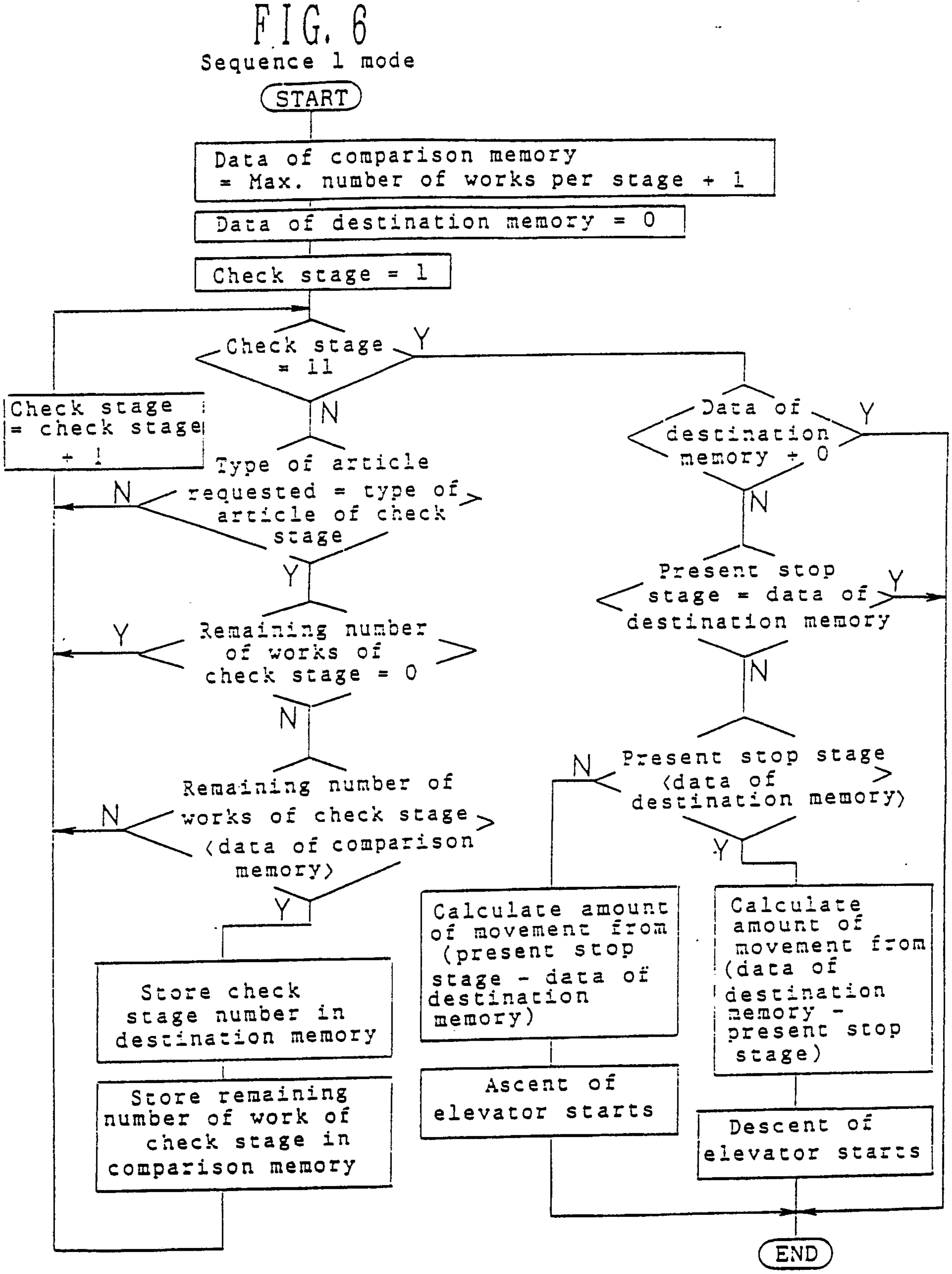
Sequence 1 mode
START
Data of comparison memory = Max. number of works per stage + 1
Data of destination memory = 0
Check stage = 1
Check stage = 11
Y
N
Check stage = check stage + 1
Type of article requested = type of article of check stage
N
Y
Remaining number of works of check stage = 0
Y
N
Remaining number of works of check stage < data of comparison memory >
N
Y
Store check stage number in destination memory
Store remaining number of work of check stage in comparison memory
Data of destination memory ≠ 0
Y
N
Present stop stage = data of destination memory
Y
N
Present stop stage < data of destination memory >
N
Y
Calculate amount of movement from (present stop stage - data of destination memory)
Ascent of elevator starts
Calculate amount of movement from (data of destination memory - present stop stage)
Descent of elevator starts
END

FIG. 7

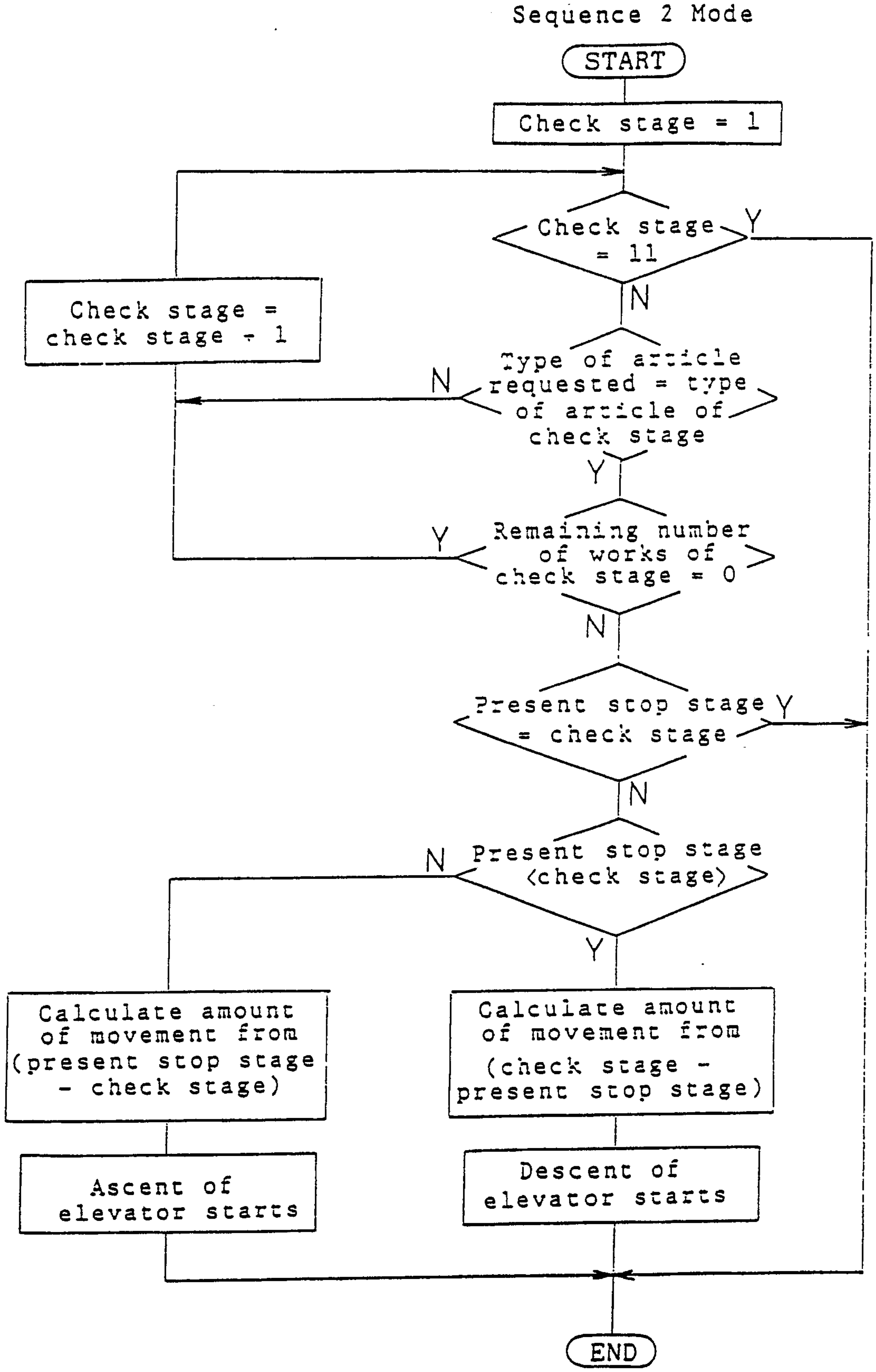
Sequence 2 Mode
START
Check stage = 1
Check stage = 11
Y
N
Check stage = check stage + 1
Type of article requested = type of article of check stage
N
Y
Remaining number of works of check stage = 0
Y
N
Present stop stage = check stage
Y
N
Present stop stage <check stage>
N
Y
Calculate amount of movement from (present stop stage - check stage)
Calculate amount of movement from (check stage - present stop stage)
Ascent of elevator starts
Descent of elevator starts
END

FIG. 8

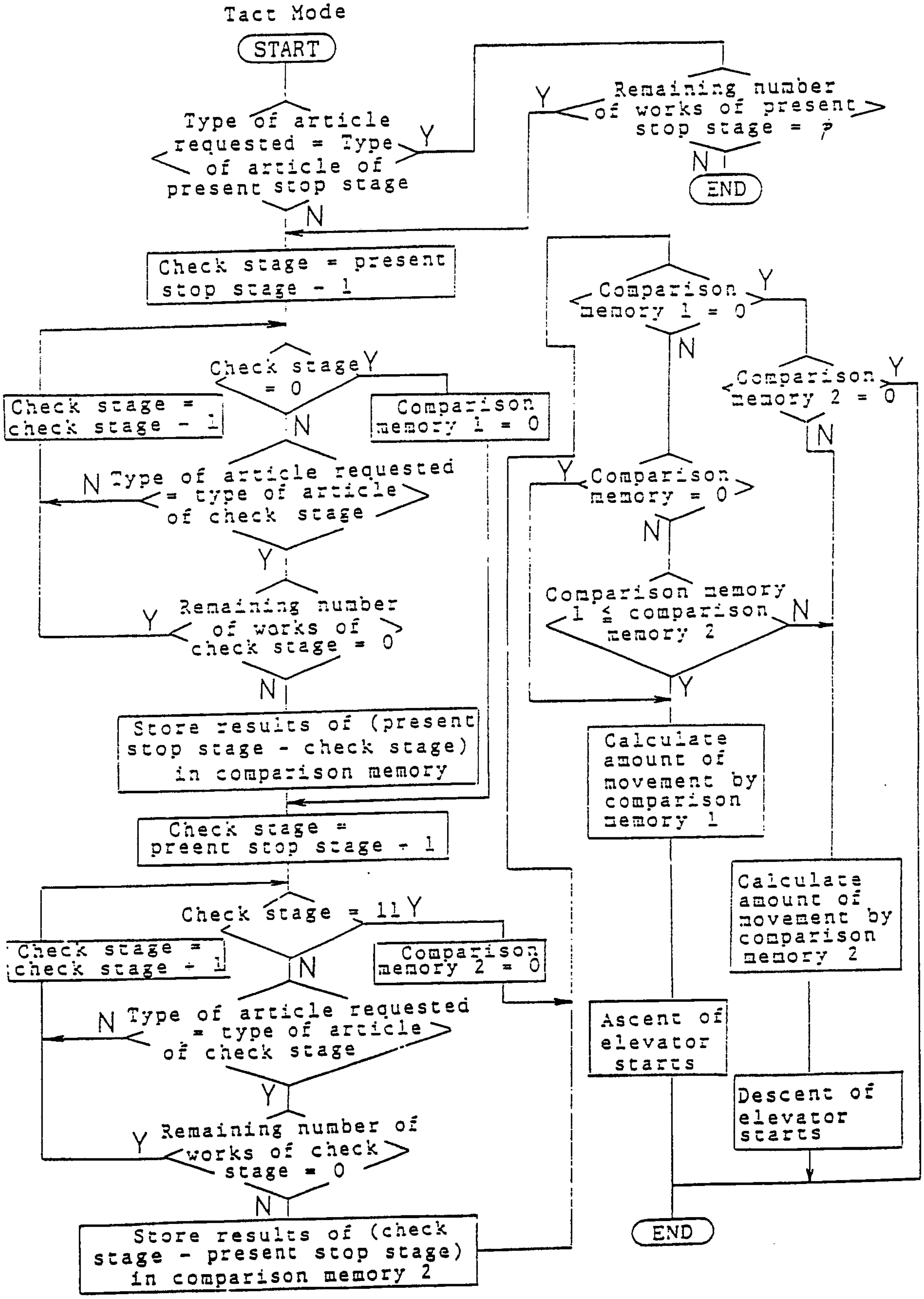
Tact Mode
START
Type of article requested = Type of article of present stop stage
Y
N
Remaining number of works of present stop stage = ?
Y
N
END
Check stage = present stop stage - 1
Check stage = 0
Y
N
Comparison memory 1 = 0
Check stage = check stage - 1
Type of article requested = type of article of check stage
N
Y
Remaining number of works of check stage = 0
Y
N
Store results of (present stop stage - check stage) in comparison memory
Check stage = preent stop stage + 1
Check stage = 11
Y
N
Comparison memory 2 = 0
Check stage = check stage + 1
Type of article requested = type of article of check stage
N
Y
Remaining number of works of check stage = 0
Y
N
Store results of (check stage - present stop stage) in comparison memory 2
Comparison memory 1 = 0
Y
N
Comparison memory 2 = 0
Y
N
Comparison memory = 0
Y
N
Comparison memory 1 ≤ comparison memory 2
N
Y
Calculate amount of movement by comparison memory 1
Calculate amount of movement by comparison memory 2
Ascent of elevator starts
Descent of elevator starts
END

FIG. 9

| Stage No. | Type of article | Remaining number of works |
|---|---|---|
| 1 | 7 | 60 |
| 2 | 1 | 0 |
| 3 | 1 | 5 |
| 4 | 10 | 8 |
| 5 | 11 | 35 |
| 6 | 7 | 30 |
| 7 | 5 | 28 |
| 8 | 7 | 20 |
| 9 | 40 | 14 |
| 10 | 50 | 6 |

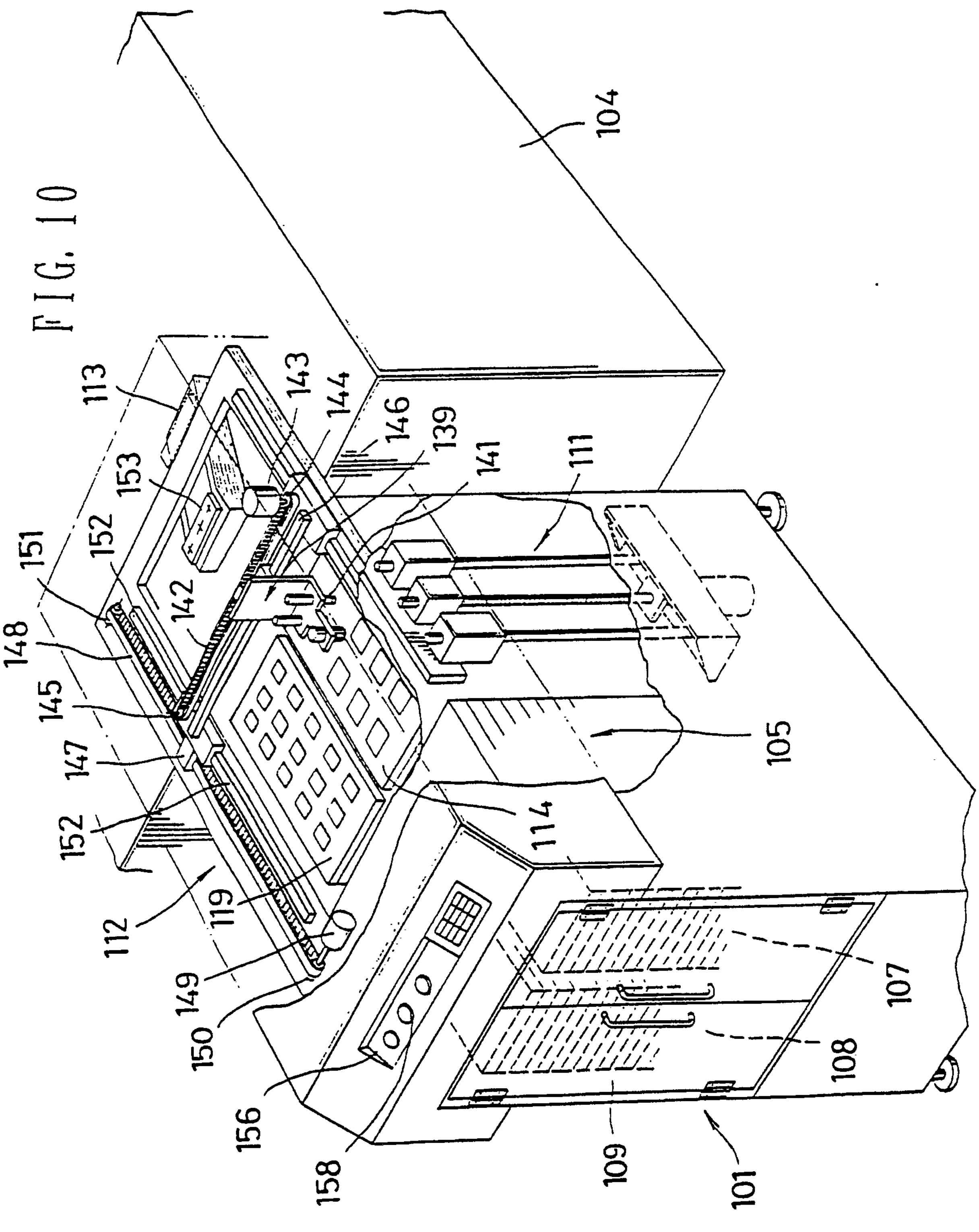

104
113
153
143
144
146
139
141
111
152
151
148
142
145
147
152
105
114
119
112
149
150
156
158
109
101
108
107


FIG. 10

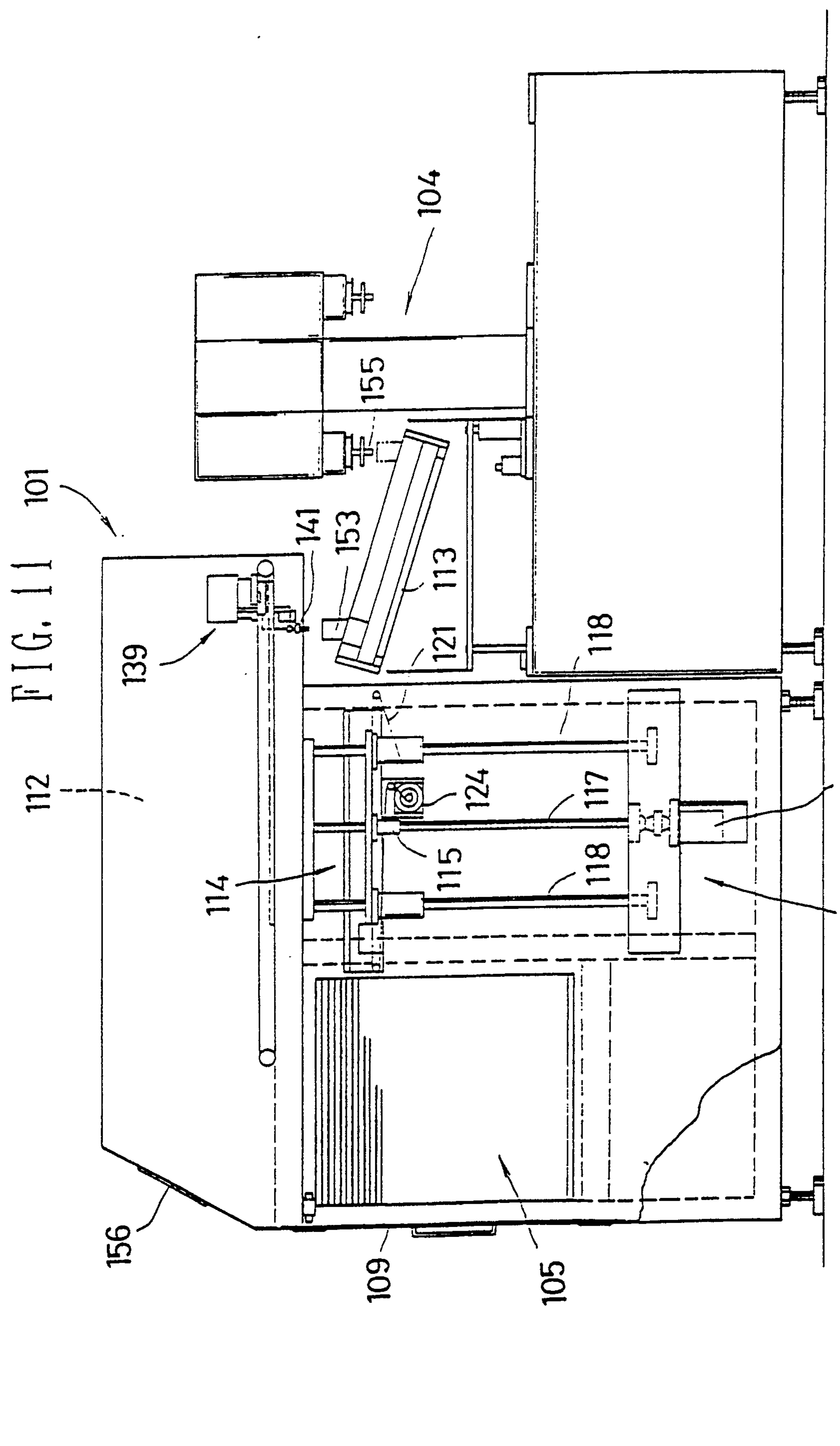
101
104
155
141
153
113
139
121
118
112
124
117
116
114
115
118
111
156
109
105

FIG. 11

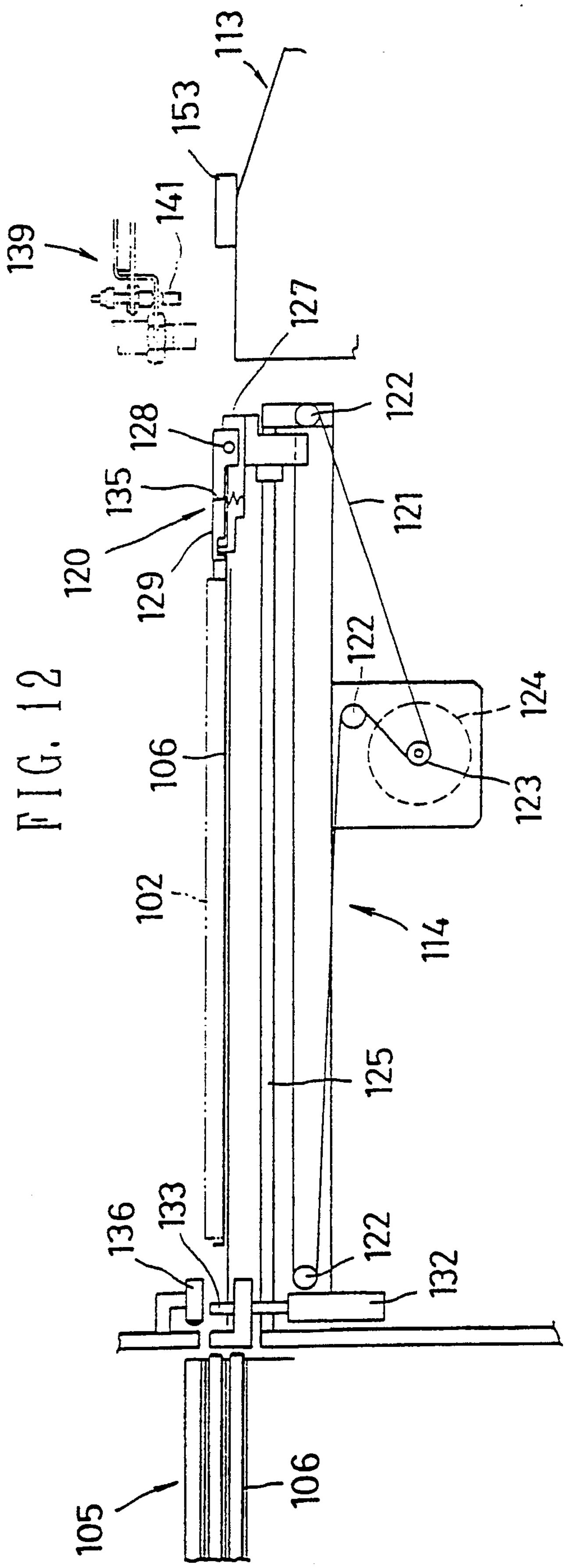
113
153
139
141
127
128
122
135
121
120
129
122
124
123
106
102
114
125
136
133
122
132
105
106

FIG. 12

FIG. 13

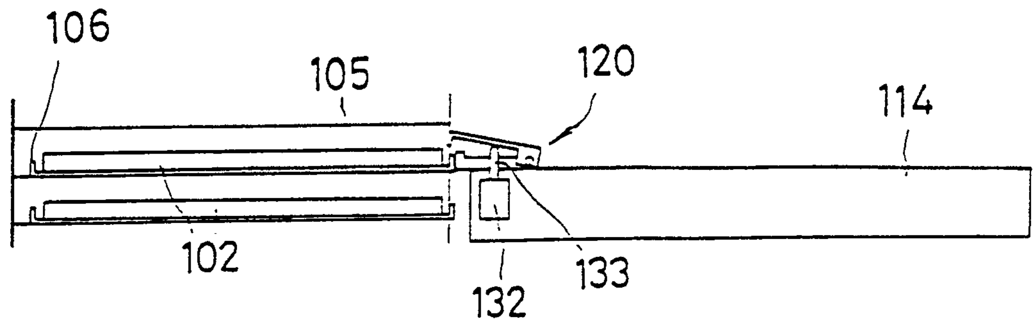


FIG. 20

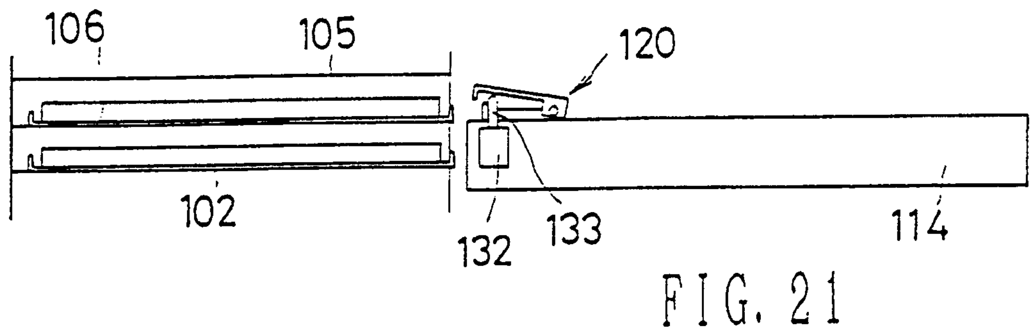


FIG. 21

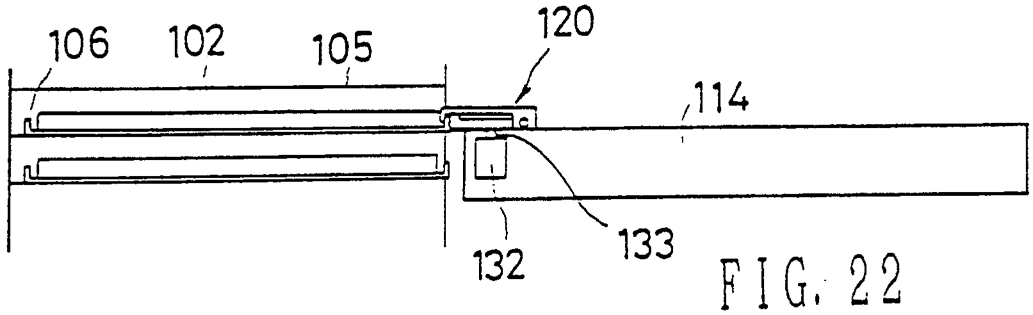


FIG. 22

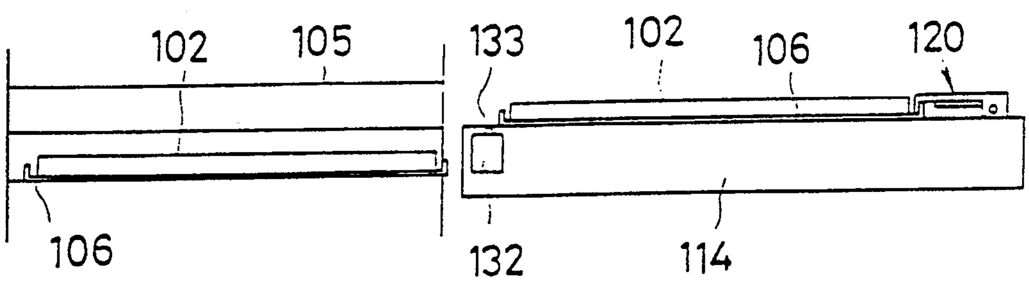

FIG. 14

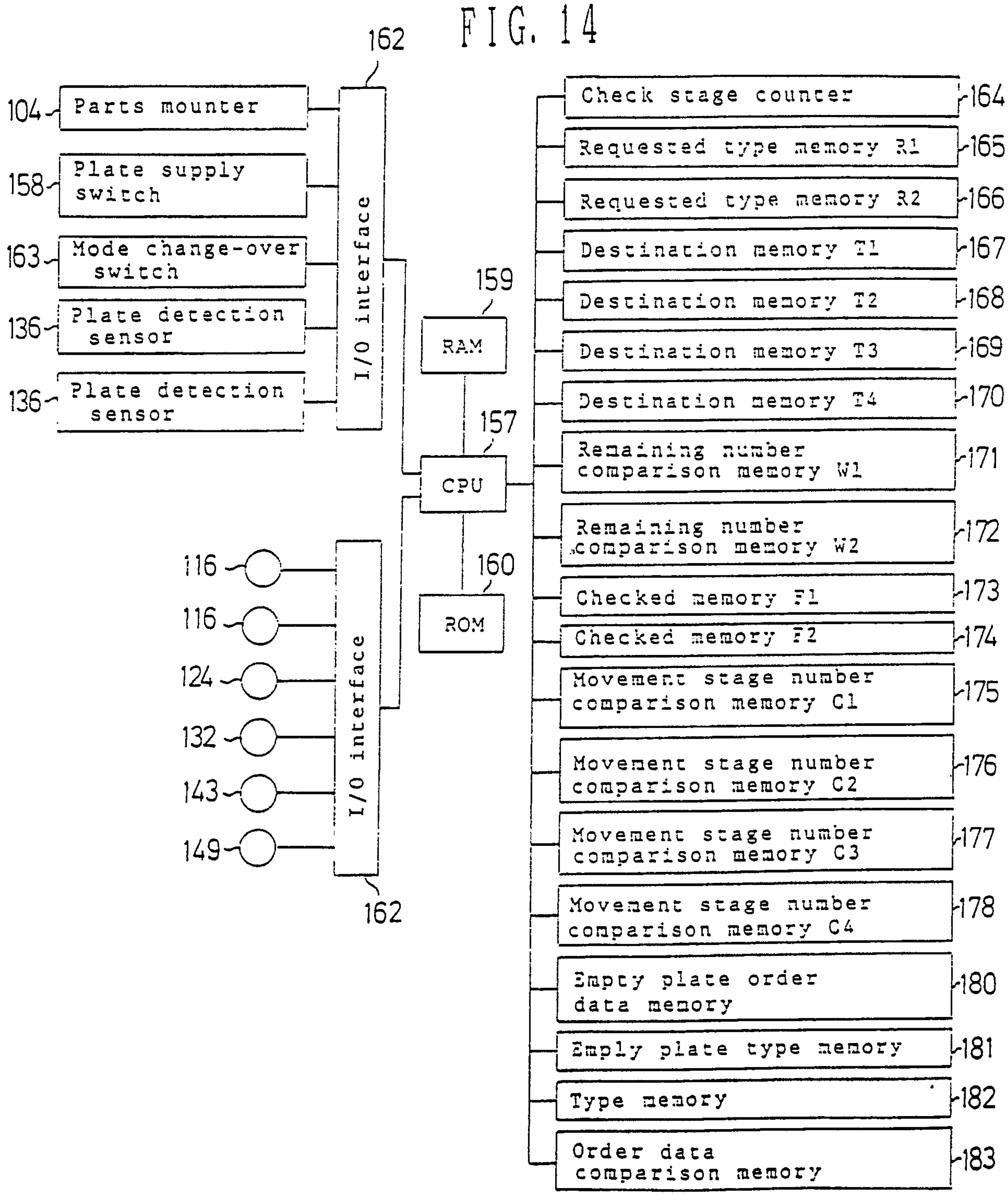

162
104 Parts mounter
158 Plate supply switch
163 Mode change-over switch
136 Plate detection sensor
136 Plate detection sensor
I/O interface
159 RAM
157 CPU
160 ROM
116
116
124
132
143
149
I/O interface
162
Check stage counter 164
Requested type memory R1 165
Requested type memory R2 166
Destination memory T1 167
Destination memory T2 168
Destination memory T3 169
Destination memory T4 170
Remaining number comparison memory W1 171
Remaining number comparison memory W2 172
Checked memory F1 173
Checked memory F2 174
Movement stage number comparison memory C1 175
Movement stage number comparison memory C2 176
Movement stage number comparison memory C3 177
Movement stage number comparison memory C4 178
Empty plate order data memory 180
Emply plate type memory 181
Type memory 182
Order data comparison memory 183

# FIG. 15

| Stage No. | Type of article | Remaining number of works | Order data | p |
|---|---|---|---|---|
| 1 | 11 | 8 | 4 | |
| 2 | 25 | 4 | 1 | |
| 3 | 80 | 50 | 2 | |
| 4 | 6 | 10 | 3 | |
| 5 | 11 | 11 | 2 | |
| 6 | 11 | 20 | 3 | |
| 7 | 1 | 15 | 1 | |
| 8 | 80 | 34 | 3 | |
| 9 | 25 | 11 | 2 | |
| 10 | 80 | 80 | 4 | |
| 11 | 25 | 10 | 4 | |
| 12 | 1 | 19 | 3 | |
| 13 | 11 | 4 | 1 | |
| 14 | 25 | 30 | 3 | |
| 15 | 6 | 21 | 1 | |
| 16 | 1 | 17 | 2 | |
| 17 | 6 | 31 | 2 | |
| 18 | 80 | 24 | 1 | |
| 19 | 6 | 3 | 2 | |
| 20 | 25 | 15 | 5 | |

FIG. 16

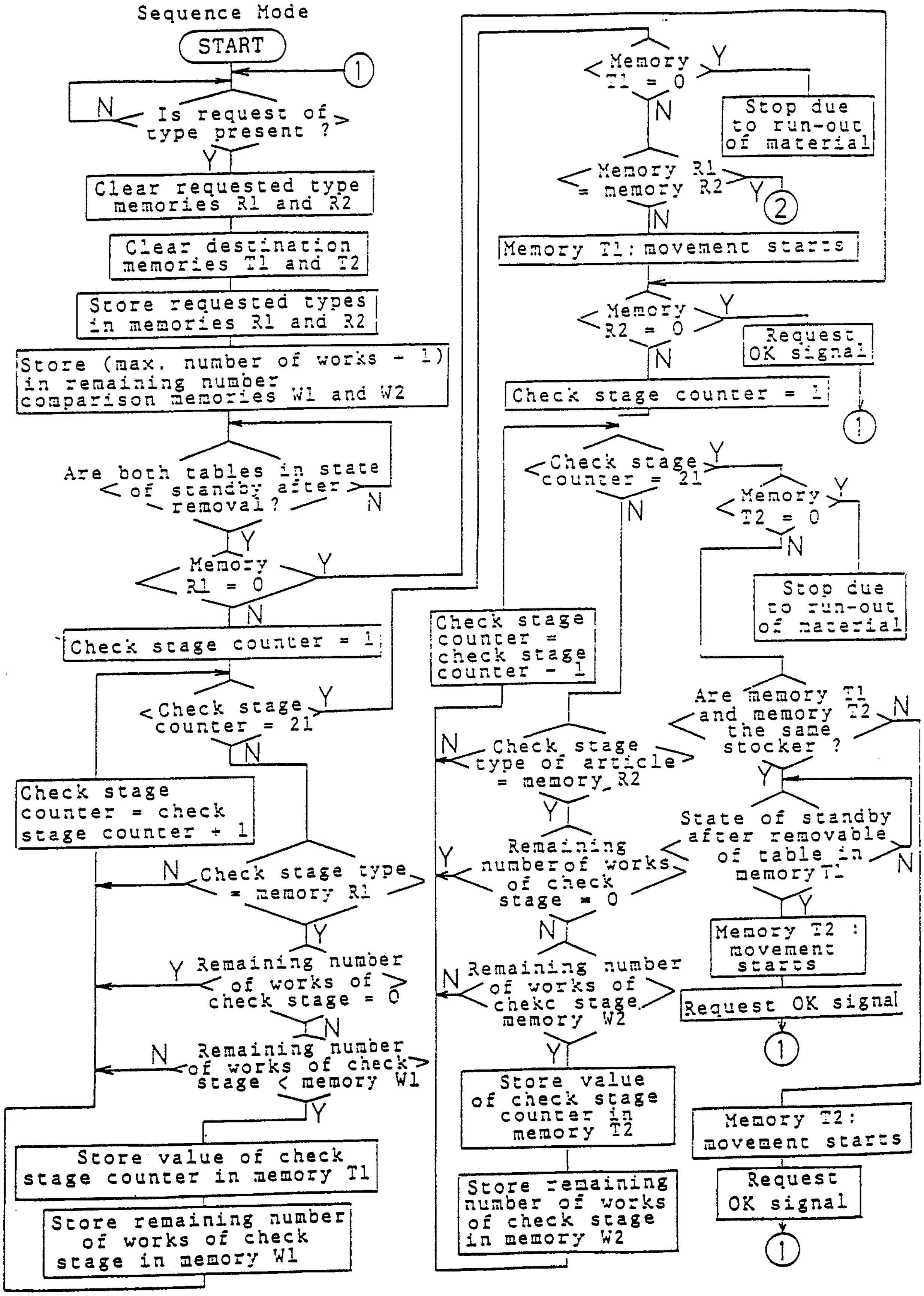
Sequence Mode
START
Is request of type present ?
Clear requested type memories R1 and R2
Clear destination memories T1 and T2
Store requested types in memories R1 and R2
Store (max. number of works - 1) in remaining number comparison memories W1 and W2
Are both tables in state of standby after removal ?
Memory R1 = 0
Check stage counter = 1
Check stage counter = 21
Check stage counter = check stage counter + 1
Check stage type = memory R1
Remaining number of works of check stage = 0
Remaining number of works of check stage < memory W1
Store value of check stage counter in memory T1
Store remaining number of works of check stage in memory W1
Memory T1 = 0
Stop due to run-out of material
Memory R1 = memory R2
Memory T1 : movement starts
Memory R2 = 0
Request OK signal
Check stage counter = 1
Check stage counter = 21
Memory T2 = 0
Stop due to run-out of material
Check stage counter = check stage counter - 1
Are memory T1 and memory T2 the same stocker ?
Check stage type of article = memory R2
State of standby after removable of table in memory T1
Remaining number of works of check stage = 0
Memory T2 : movement starts
Request OK signal
Remaining number of works of chekc stage memory W2
Store value of check stage counter in memory T2
Store remaining number of works of check stage in memory W2
Memory T2: movement starts
Request OK signal

FIG. 17

Sequence Mode

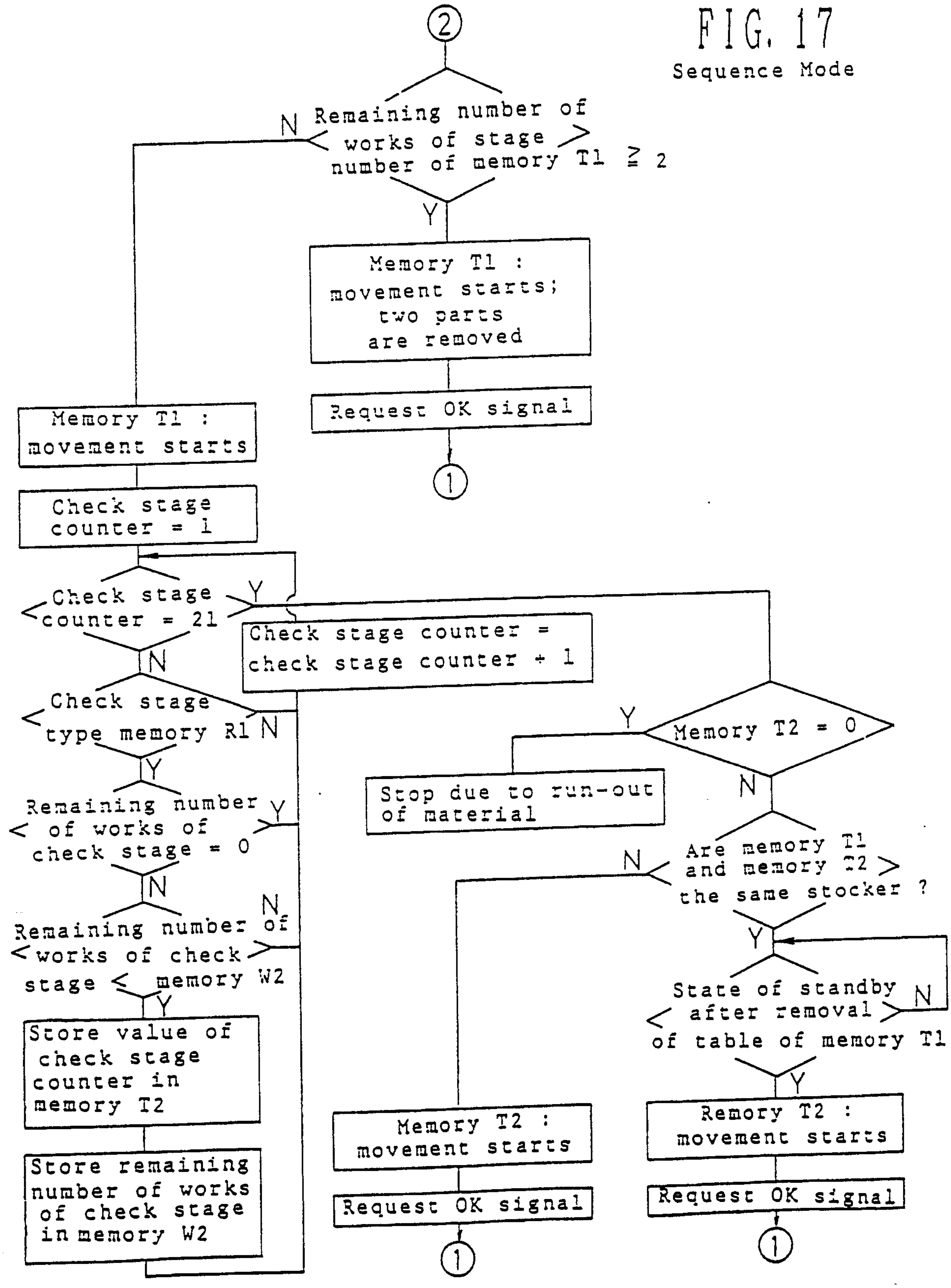

FIG. 18

Operation after instruction of starting movement of table for the removal of one part

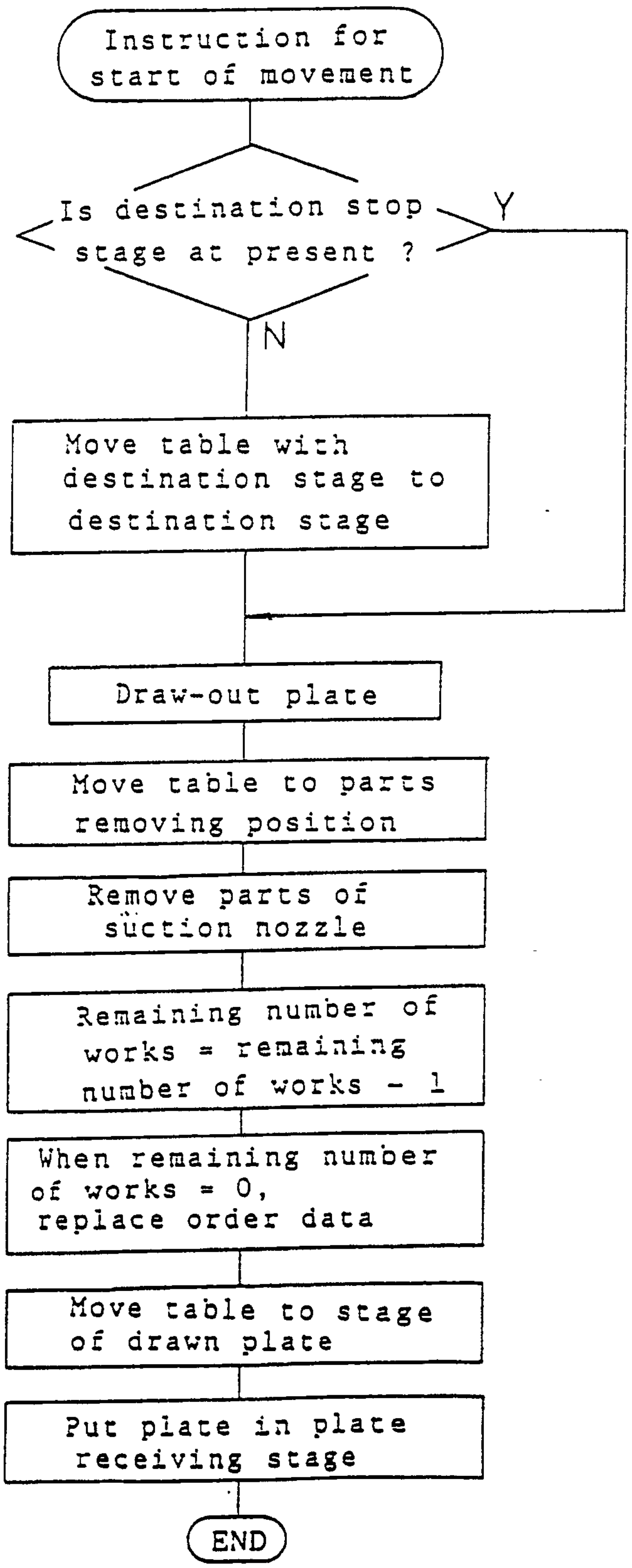

FIG. 19

Operation after instruction of starting movement of table for removal of two parts

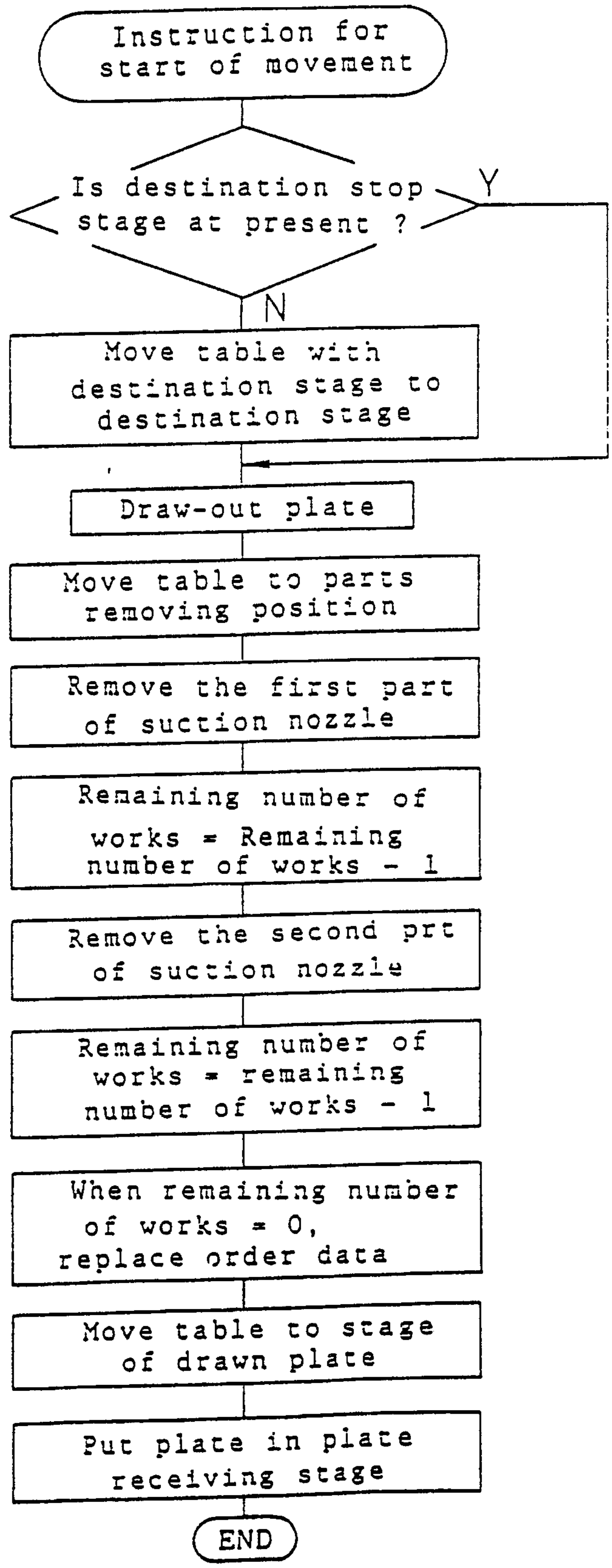

FIG. 23

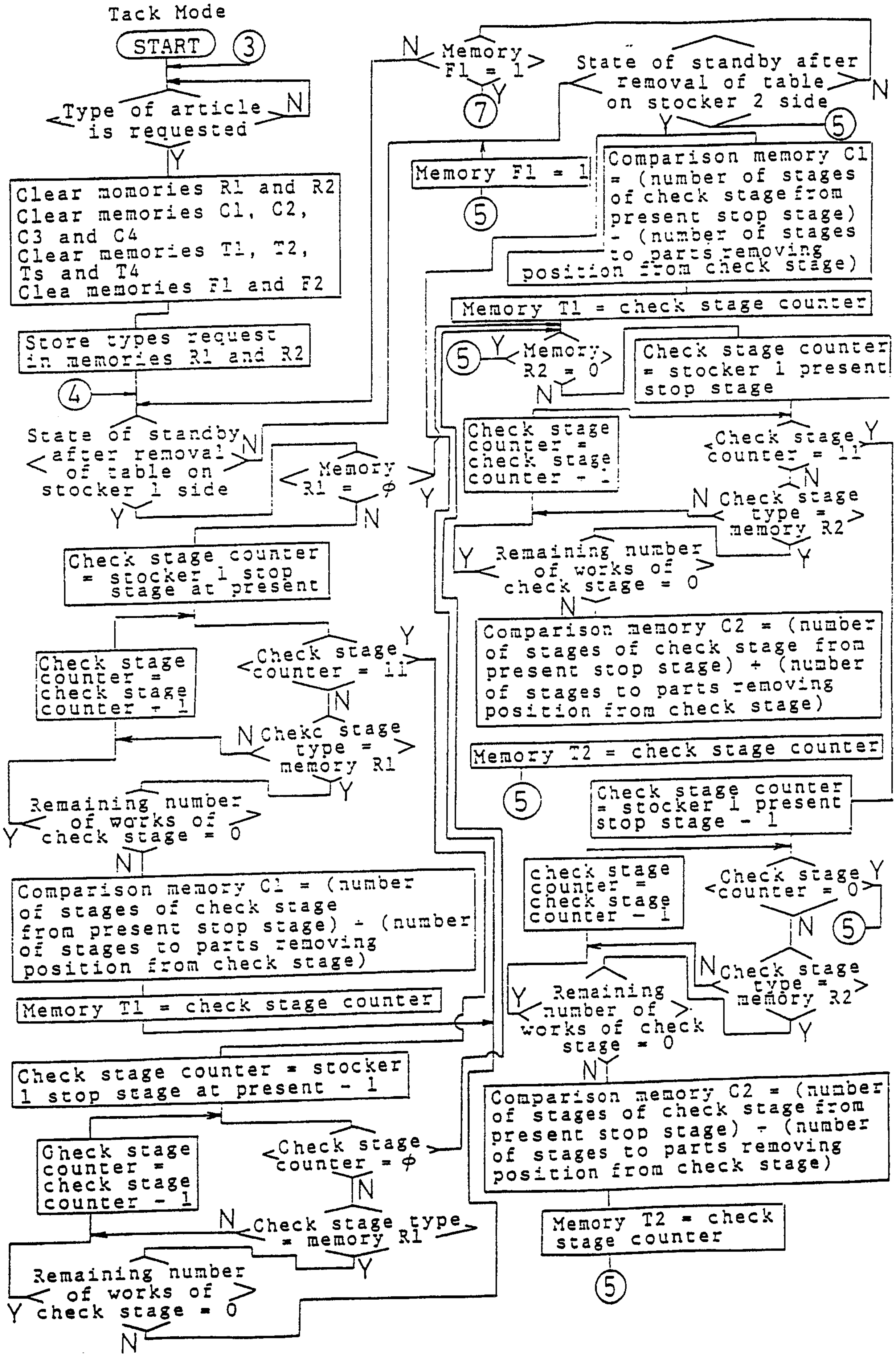

Tack Mode
START
3
Type of article is requested
N
Y
Clear momories R1 and R2
Clear memories C1, C2, C3 and C4
Clear memories T1, T2, Ts and T4
Clea memories F1 and F2
Store types request in memories R1 and R2
4
State of standby after removal of table on stocker 1 side
N
Y
Memory R1 = φ
Y
N
Check stage counter = stocker 1 stop stage at present
Check stage counter = check stage counter + 1
Check stage counter = 11
Y
N
Chekc stage type = memory R1
N
Y
Remaining number of works of check stage = 0
Y
N
Comparison memory C1 = (number of stages of check stage from present stop stage) + (number of stages to parts removing position from check stage)
Memory T1 = check stage counter
Check stage counter = stocker 1 stop stage at present - 1
Check stage counter = check stage counter - 1
Check stage counter = φ
N
Check stage type = memory R1
N
Y
Remaining number of works of check stage = 0
Y
N
Memory F1 = 1
N
Y
7
Memory F1 = 1
5
State of standby after removal of table on stocker 2 side
N
Y
5
Comparison memory C1 = (number of stages of check stage from present stop stage) - (number of stages to parts removing position from check stage)
Memory T1 = check stage counter
5
Memory R2 = 0
Y
N
Check stage counter = stocker 1 present stop stage
Check stage counter = check stage counter + 1
Check stage counter = 11
Y
N
Check stage type = memory R2
N
Y
Remaining number of works of check stage = 0
Y
N
Comparison memory C2 = (number of stages of check stage from present stop stage) + (number of stages to parts removing position from check stage)
Memory T2 = check stage counter
5
Check stage counter = stocker 1 present stop stage - 1
check stage counter = check stage counter - 1
Check stage counter = 0
Y
5
N
Check stage type = memory R2
N
Y
Remaining number of works of check stage = 0
Y
N
Comparison memory C2 = (number of stages of check stage from present stop stage) + (number of stages to parts removing position from check stage)
Memory T2 = check stage counter
5

FIG. 24

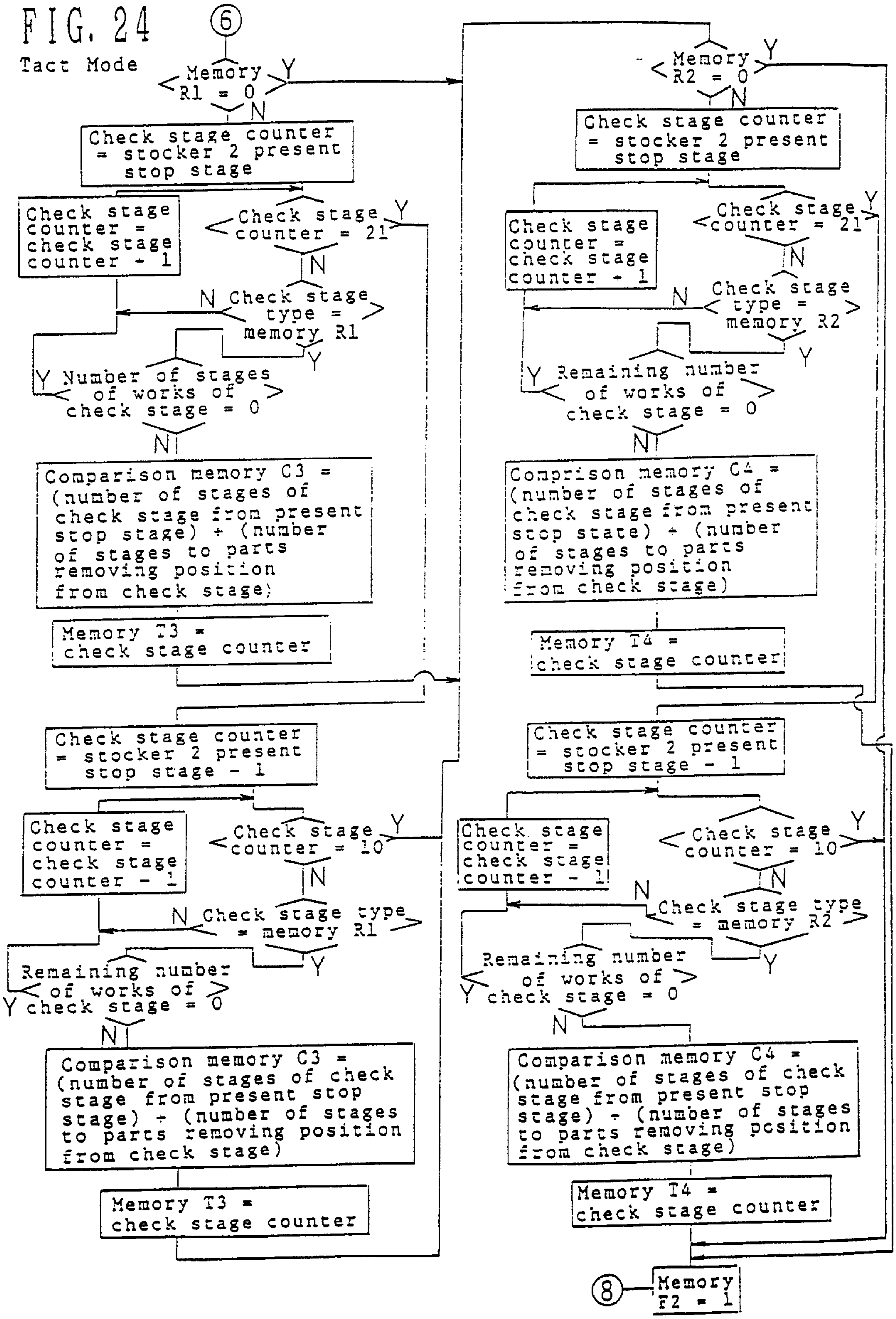

6
Tact Mode
Memory R1 = 0
Y
N
Check stage counter = stocker 2 present stop stage
Check stage counter = check stage counter + 1
Check stage counter = 21
Check stage type = memory R1
Number of stages of works of check stage = 0
Comparison memory C3 = (number of stages of check stage from present stop stage) ÷ (number of stages to parts removing position from check stage)
Memory T3 = check stage counter
Check stage counter = stocker 2 present stop stage - 1
Check stage counter = check stage counter - 1
Check stage counter = 10
Check stage type = memory R1
Remaining number of works of check stage = 0
Comparison memory C3 = (number of stages of check stage from present stop stage) ÷ (number of stages to parts removing position from check stage)
Memory T3 = check stage counter
Memory R2 = 0
Check stage counter = stocker 2 present stop stage
Check stage counter = check stage counter + 1
Check stage counter = 21
Check stage type = memory R2
Remaining number of works of check stage = 0
Comprison memory C4 = (number of stages of check stage from present stop state) ÷ (number of stages to parts removing position from check stage)
Memory T4 = check stage counter
Check stage counter = stocker 2 present stop stage - 1
Check stage counter = check stage counter - 1
Check stage counter = 10
Check stage type = memory R2
Remaining number of works of check stage = 0
Comparison memory C4 = (number of stages of check stage from present stop stage) ÷ (number of stages to parts removing position from check stage)
Memory T4 = check stage counter
8
Memory F2 = 1

FIG. 25

Tact Mode

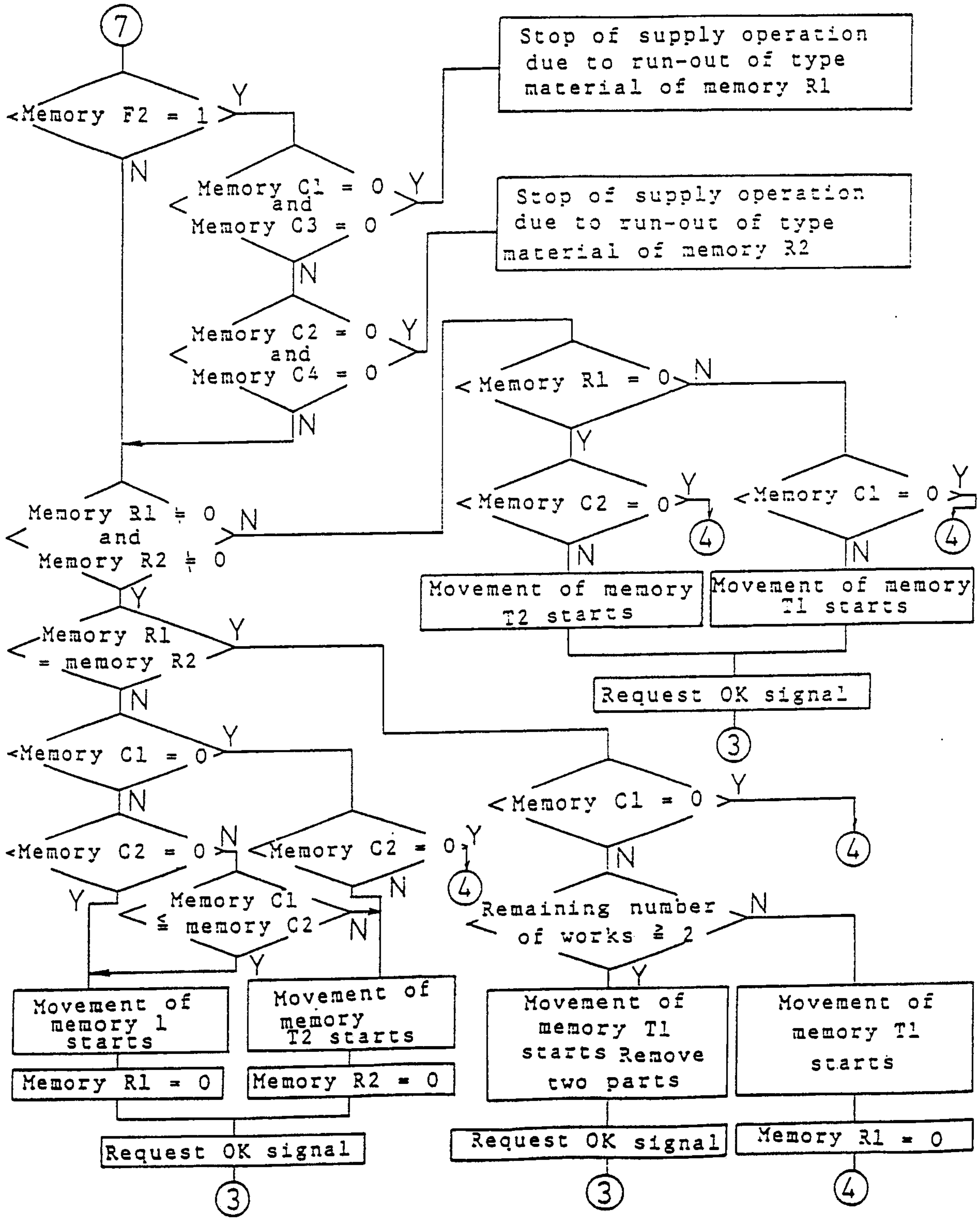

FIG. 26

Tact Mode

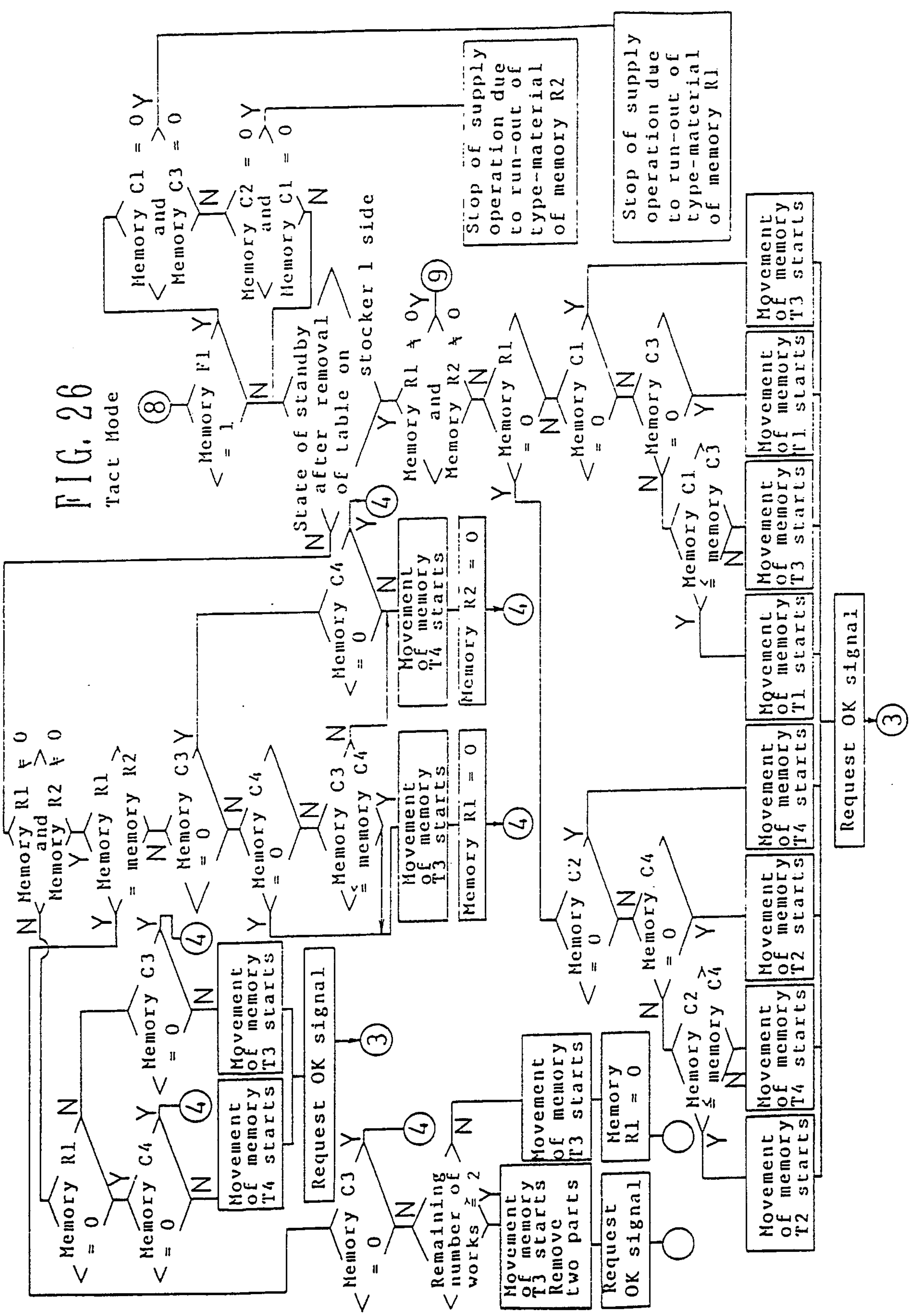

FIG. 27
Tact Mode

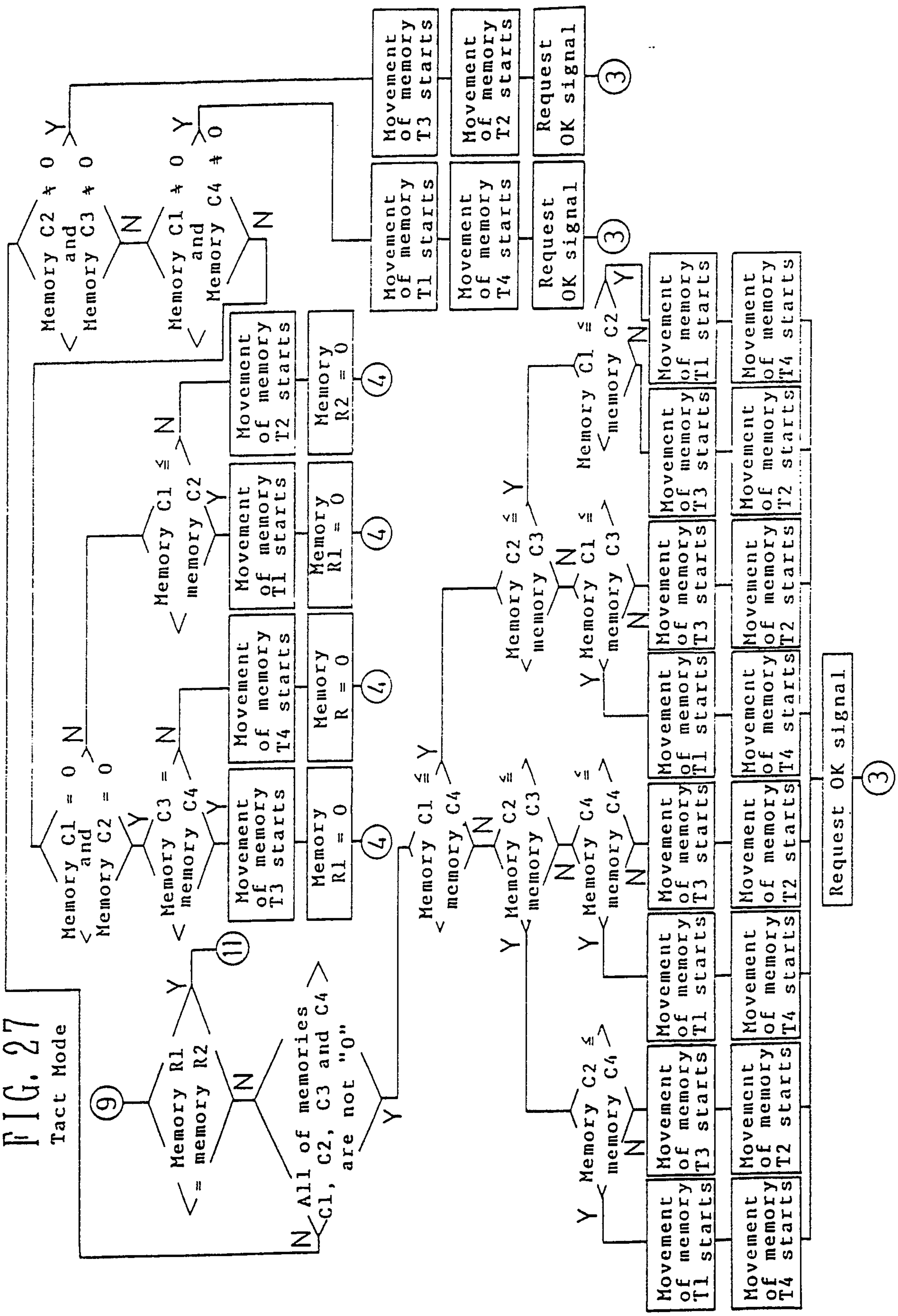

FIG. 28

Tact Mode

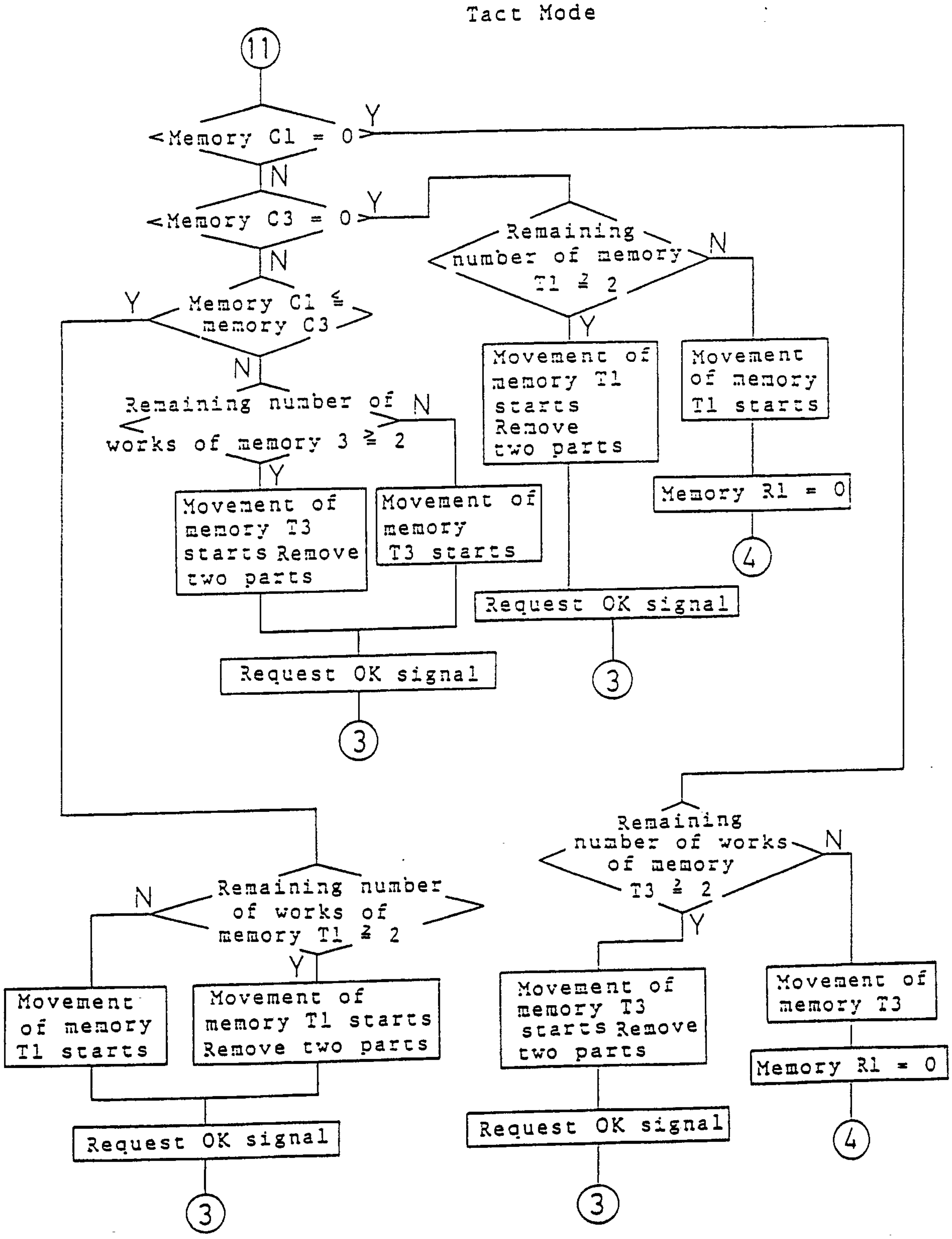

FIG. 29

| Stage No. | Type of article | Remaining number of works | Order data | p |
|---|---|---|---|---|
| 1 | 11 | 8 | 4 | |
| 2 | 25 | 3 | 1 | |
| 3 | 80 | 50 | 2 | |
| 4 | 6 | 10 | 3 | |
| 5 | 11 | 11 | 2 | |
| 6 | 11 | 20 | 3 | |
| 7 | 1 | 15 | 1 | |
| 8 | 80 | 34 | 3 | |
| 9 | 25 | 11 | 2 | |
| 10 | 80 | 80 | 4 | |
| 11 | 25 | 10 | 4 | |
| 12 | 1 | 19 | 3 | |
| 13 | 11 | 3 | 1 | |
| 14 | 25 | 30 | 3 | |
| 15 | 6 | 21 | 1 | |
| 16 | 1 | 17 | 2 | |
| 17 | 6 | 31 | 2 | |
| 18 | 80 | 24 | 1 | |
| 19 | 6 | 3 | 2 | |
| 20 | 25 | 15 | 5 | |

FIG. 30 Early In- and Out Mode

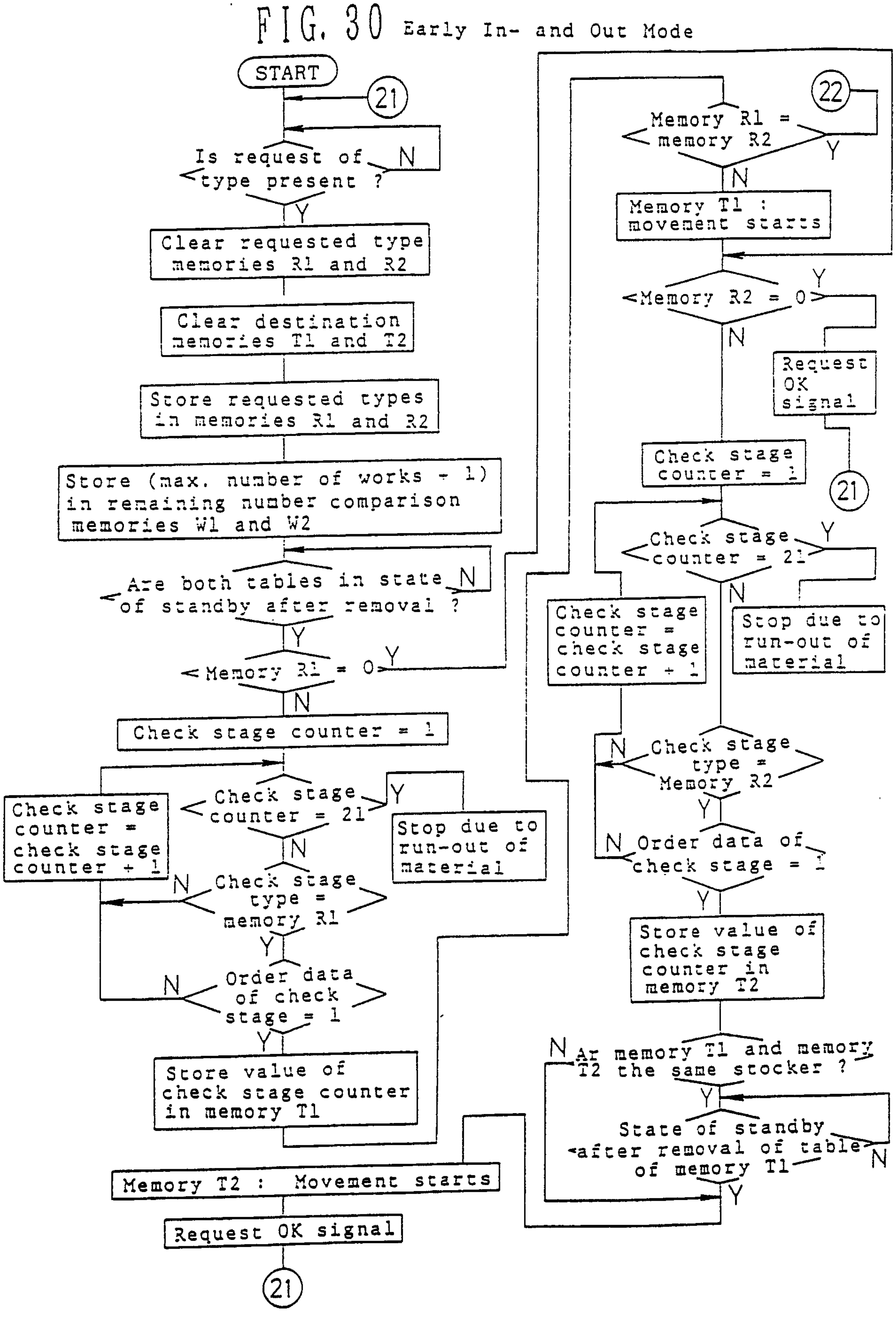

FIG. 31

Early In- and Out Mode

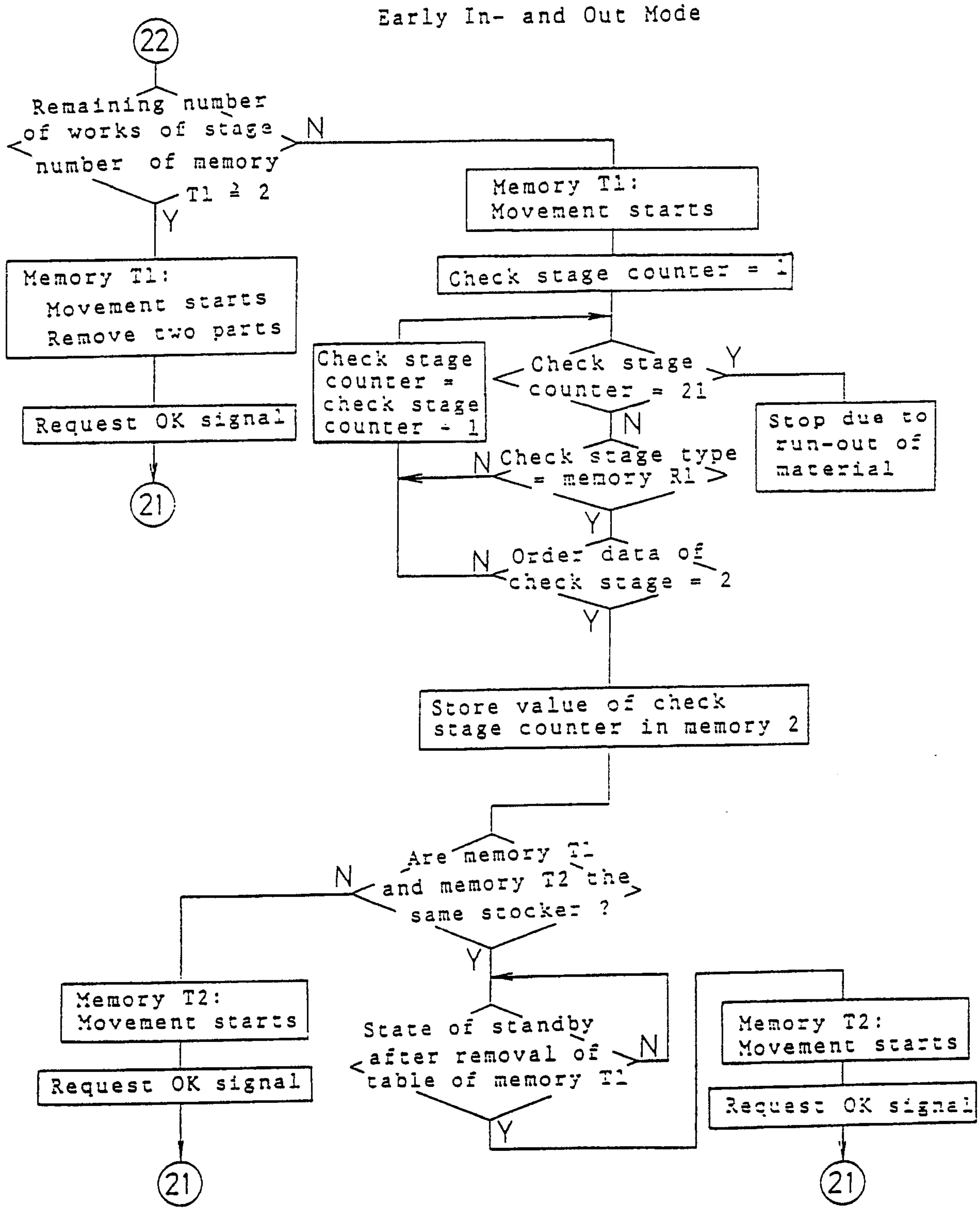

FIG. 32

| Stage No. | Type of article | Remaining number of works | Order data | P |
|---|---|---|---|---|
| 1 | 11 | 8 | 4 | |
| 2 | 25 | 3 | 1 | |
| 3 | 80 | 50 | 2 | |
| 4 | 6 | 10 | 3 | |
| 5 | 11 | 10 | 2 | |
| 6 | 11 | 20 | 3 | |
| 7 | 1 | 15 | 1 | |
| 8 | 80 | 34 | 3 | |
| 9 | 25 | 11 | 2 | |
| 10 | 80 | 80 | 4 | |
| 11 | 25 | 10 | 4 | |
| 12 | 1 | 19 | 3 | |
| 13 | 11 | 3 | 1 | |
| 14 | 25 | 30 | 3 | |
| 15 | 6 | 21 | 1 | |
| 16 | 1 | 17 | 2 | |
| 17 | 6 | 31 | 2 | |
| 18 | 80 | 23 | 1 | |
| 19 | 6 | 3 | 2 | |
| 20 | 25 | 15 | 5 | |

FIG. 33

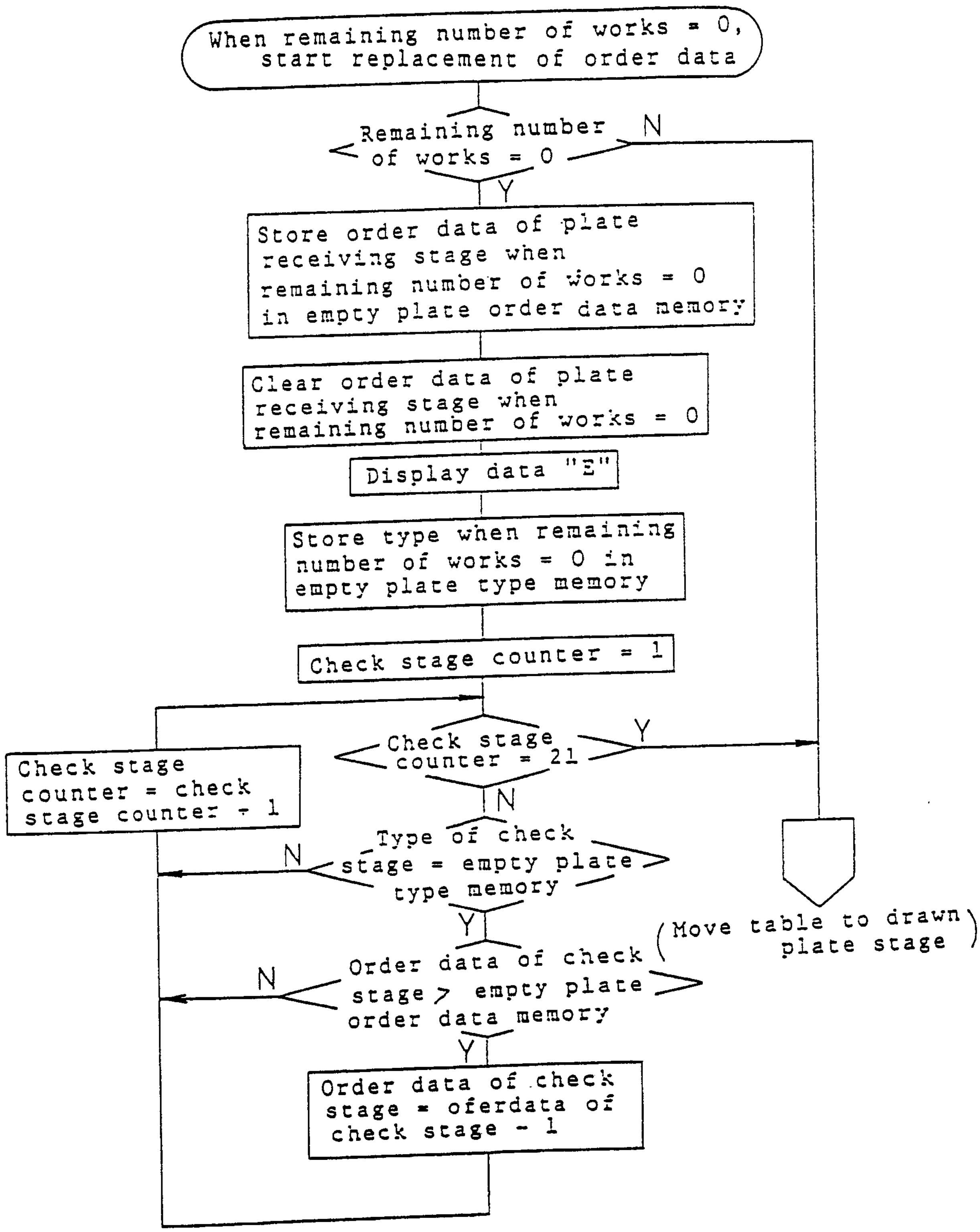
When remaining number of works = 0, start replacement of order data
Remaining number of works = 0
N
Y
Store order data of plate receiving stage when remaining number of works = 0 in empty plate order data memory
Clear order data of plate receiving stage when remaining number of works = 0
Display data "E"
Store type when remaining number of works = 0 in empty plate type memory
Check stage counter = 1
Check stage counter = 21
Y
N
Check stage counter = check stage counter + 1
Type of check stage = empty plate type memory
N
Y
Order data of check stage > empty plate order data memory
N
Y
Order data of check stage = oferdata of check stage - 1
(Move table to drawn plate stage)

FIG. 34

| Stage No. | Type of article | Remaining number of works | Order data | p |
|---|---|---|---|---|
| 1 | 11 | 8 | 4 | |
| 2 | 25 | 0 | 0 | E |
| 3 | 80 | 50 | 2 | |
| 4 | 6 | 10 | 3 | |
| 5 | 11 | 10 | 2 | |
| 6 | 11 | 20 | 3 | |
| 7 | 1 | 15 | 1 | |
| 8 | 80 | 34 | 3 | |
| 9 | 25 | 11 | 1 | |
| 10 | 80 | 80 | 4 | |
| 11 | 25 | 10 | 3 | |
| 12 | 1 | 19 | 3 | |
| 13 | 11 | 3 | 1 | |
| 14 | 25 | 30 | 2 | |
| 15 | 6 | 20 | 1 | |
| 16 | 1 | 17 | 2 | |
| 17 | 6 | 31 | 2 | |
| 18 | 80 | 23 | 1 | |
| 19 | 6 | 3 | 2 | |
| 20 | 25 | 15 | 4 | |

FIG. 35

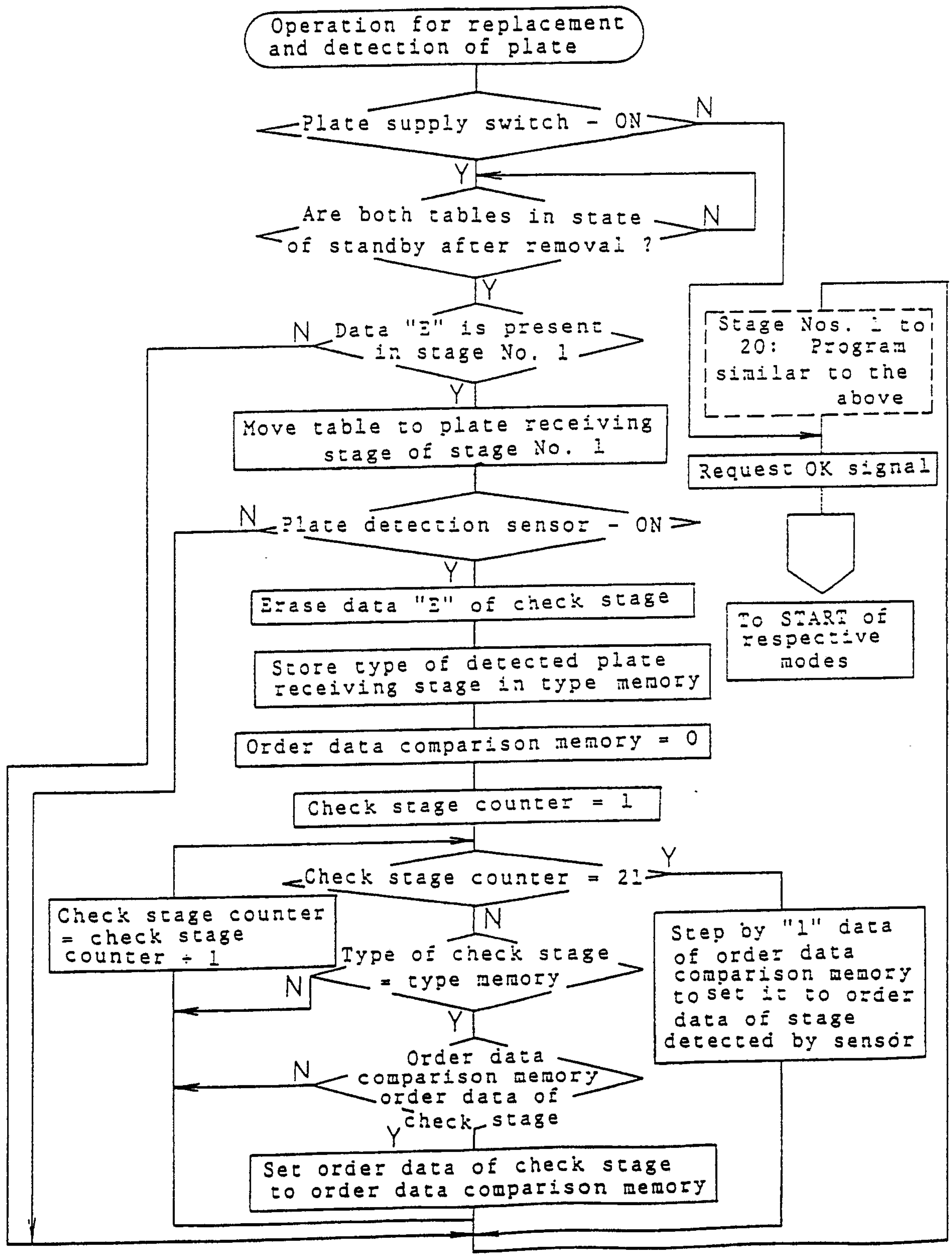

Operation for replacement and detection of plate
Plate supply switch - ON
N
Y
Are both tables in state of standby after removal ?
N
Y
Data "E" is present in stage No. 1
N
Y
Move table to plate receiving stage of stage No. 1
Plate detection sensor - ON
N
Y
Erase data "E" of check stage
Store type of detected plate receiving stage in type memory
Order data comparison memory = 0
Check stage counter = 1
Check stage counter = 21
Y
N
Check stage counter = check stage counter + 1
Type of check stage = type memory
N
Y
Order data comparison memory order data of check stage
N
Y
Set order data of check stage to order data comparison memory
Step by "1" data of order data comparison memory to set it to order data of stage detected by sensor
Stage Nos. 1 to 20: Program similar to the above
Request OK signal
To START of respective modes

FIG. 36

| Stage No. | Type of article | Remaining number of works | Order data | p |
|---|---|---|---|---|
| 1 | 11 | 8 | 4 | |
| 2 | 25 | 35 | 5 | |
| 3 | 80 | 50 | 2 | |
| 4 | 6 | 10 | 3 | |
| 5 | 11 | 10 | 2 | |
| 6 | 11 | 20 | 3 | |
| 7 | 1 | 15 | 1 | |
| 8 | 80 | 34 | 3 | |
| 9 | 25 | 11 | 1 | |
| 10 | 80 | 80 | 4 | |
| 11 | 25 | 10 | 3 | |
| 12 | 1 | 19 | 3 | |
| 13 | 11 | 3 | 1 | |
| 14 | 25 | 30 | 2 | |
| 15 | 6 | 20 | 1 | |
| 16 | 1 | 17 | 2 | |
| 17 | 6 | 31 | 2 | |
| 18 | 80 | 23 | 1 | |
| 19 | 6 | 3 | 2 | |
| 20 | 25 | 15 | 4 | |

FIG. 37

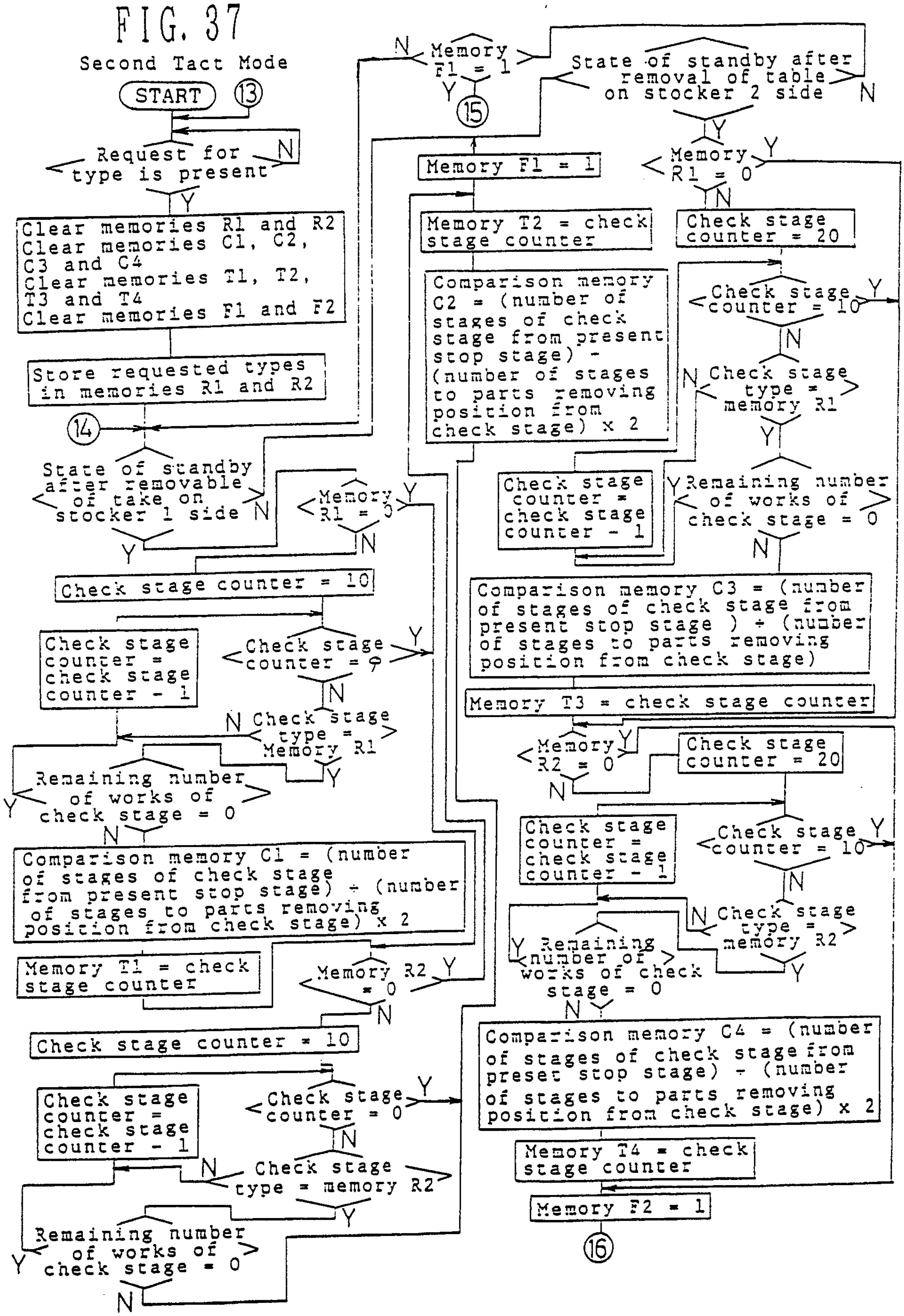
Second Tact Mode
START
13
Request for type is present
Clear memories R1 and R2
Clear memories C1, C2, C3 and C4
Clear memories T1, T2, T3 and T4
Clear memories F1 and F2
Store requested types in memories R1 and R2
14
State of standby after removable of take on stocker 1 side
Memory R1 = 0
Check stage counter = 10
Check stage counter = 9
Check stage counter = check stage counter - 1
Check stage type = Memory R1
Remaining number of works of check stage = 0
Comparison memory C1 = (number of stages of check stage from present stop stage) ÷ (number of stages to parts removing position from check stage) x 2
Memory T1 = check stage counter
Memory R2 = 0
Check stage counter = 10
Check stage counter = 0
Check stage counter = check stage counter - 1
Check stage type = memory R2
Remaining number of works of check stage = 0
Memory F1 = 1
15
Memory F1 = 1
Memory T2 = check stage counter
Comparison memory C2 = (number of stages of check stage from present stop stage) - (number of stages to parts removing position from check stage) x 2
State of standby after removal of table on stocker 2 side
Memory R1 = 0
Check stage counter = 20
Check stage counter = 10
Check stage type = memory R1
Check stage counter = check stage counter - 1
Remaining number of works of check stage = 0
Comparison memory C3 = (number of stages of check stage from present stop stage ) ÷ (number of stages to parts removing position from check stage)
Memory T3 = check stage counter
Memory R2 = 0
Check stage counter = 20
Check stage counter = check stage counter - 1
Check stage counter = 10
Check stage type = memory R2
Remaining number of works of check stage = 0
Comparison memory C4 = (number of stages of check stage from preset stop stage) ÷ (number of stages to parts removing position from check stage) x 2
Memory T4 = check stage counter
Memory F2 = 1
16
Y
N

FIG. 38

Second Tact Mode

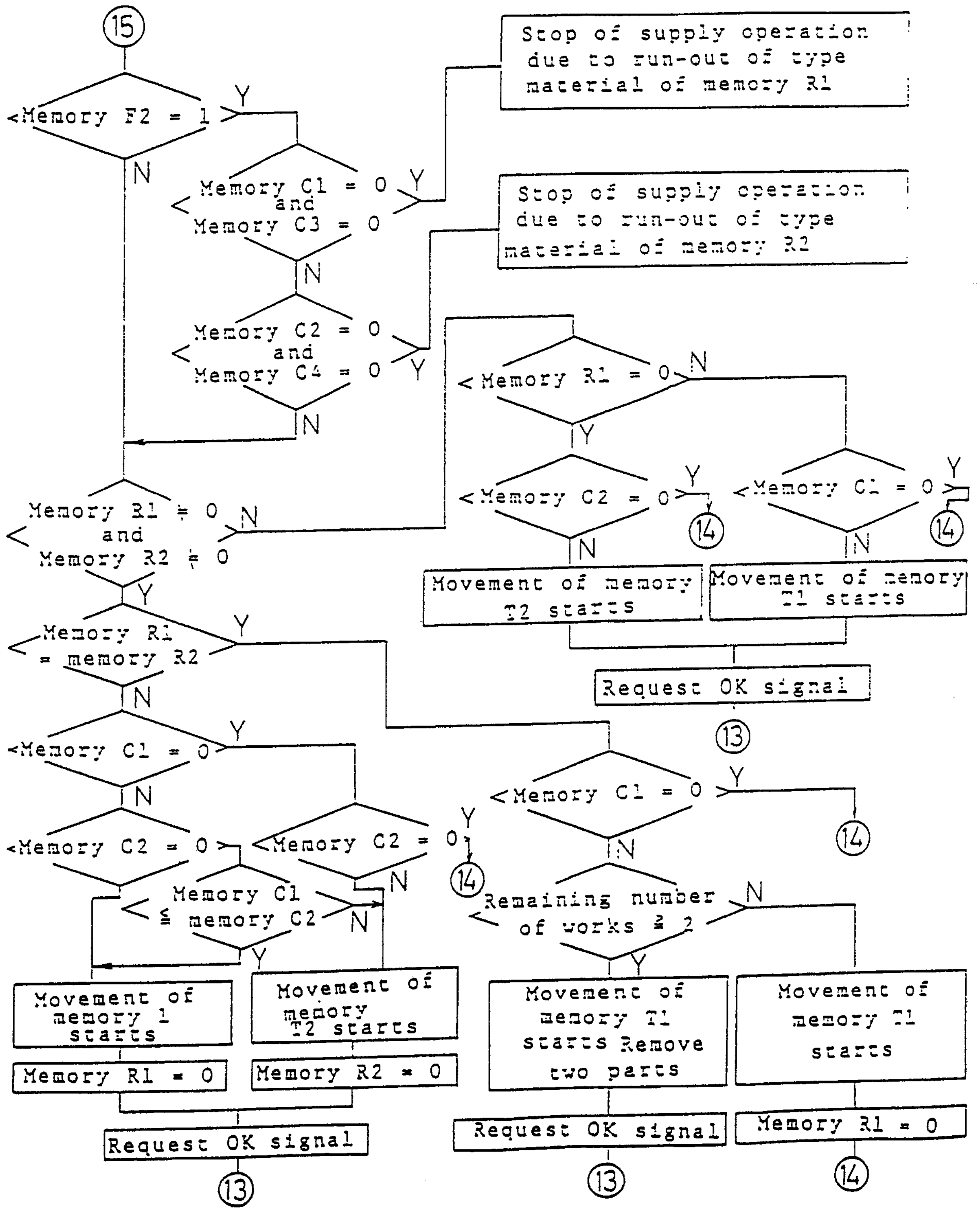

FIG. 39

Second Tact Mode

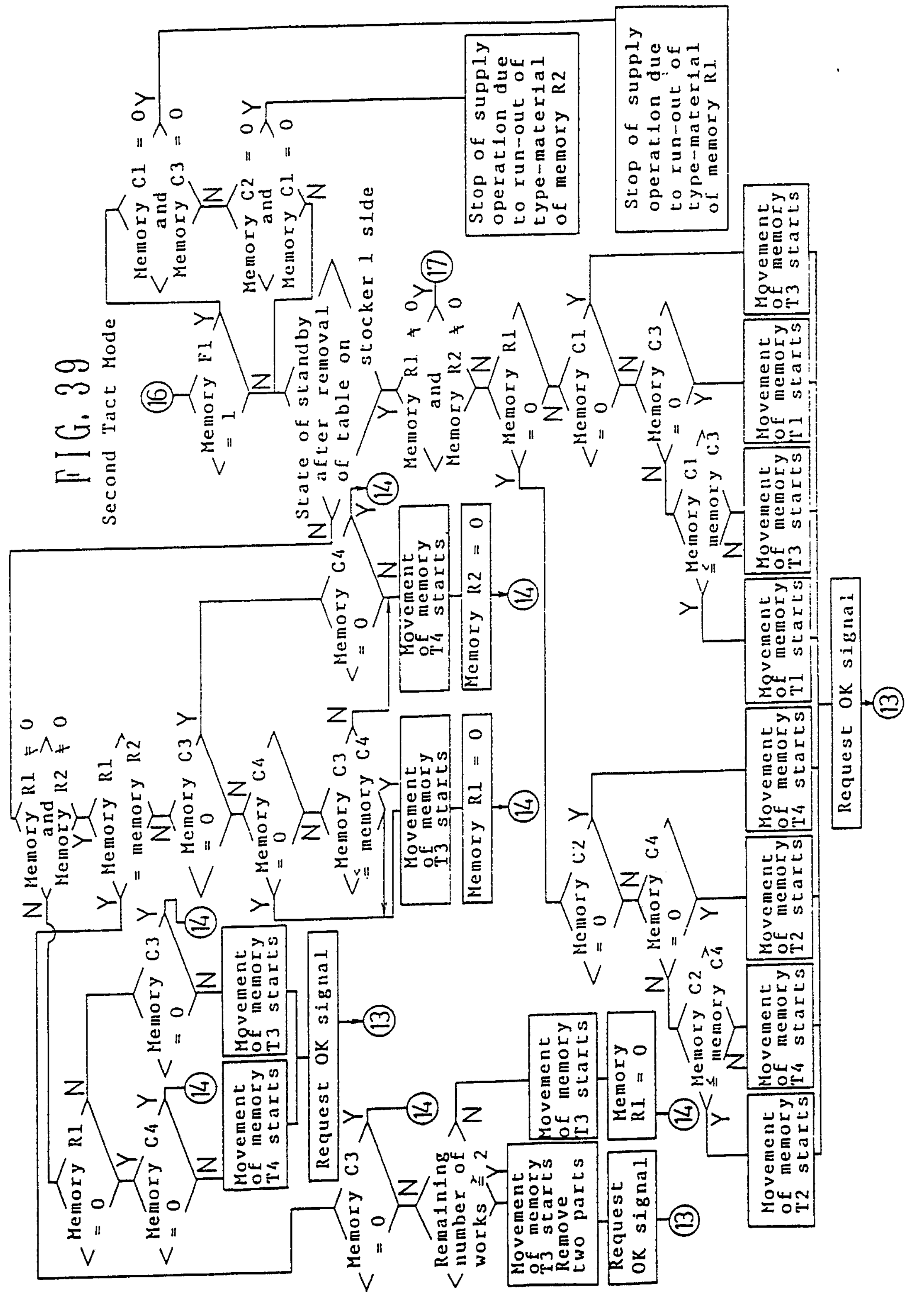

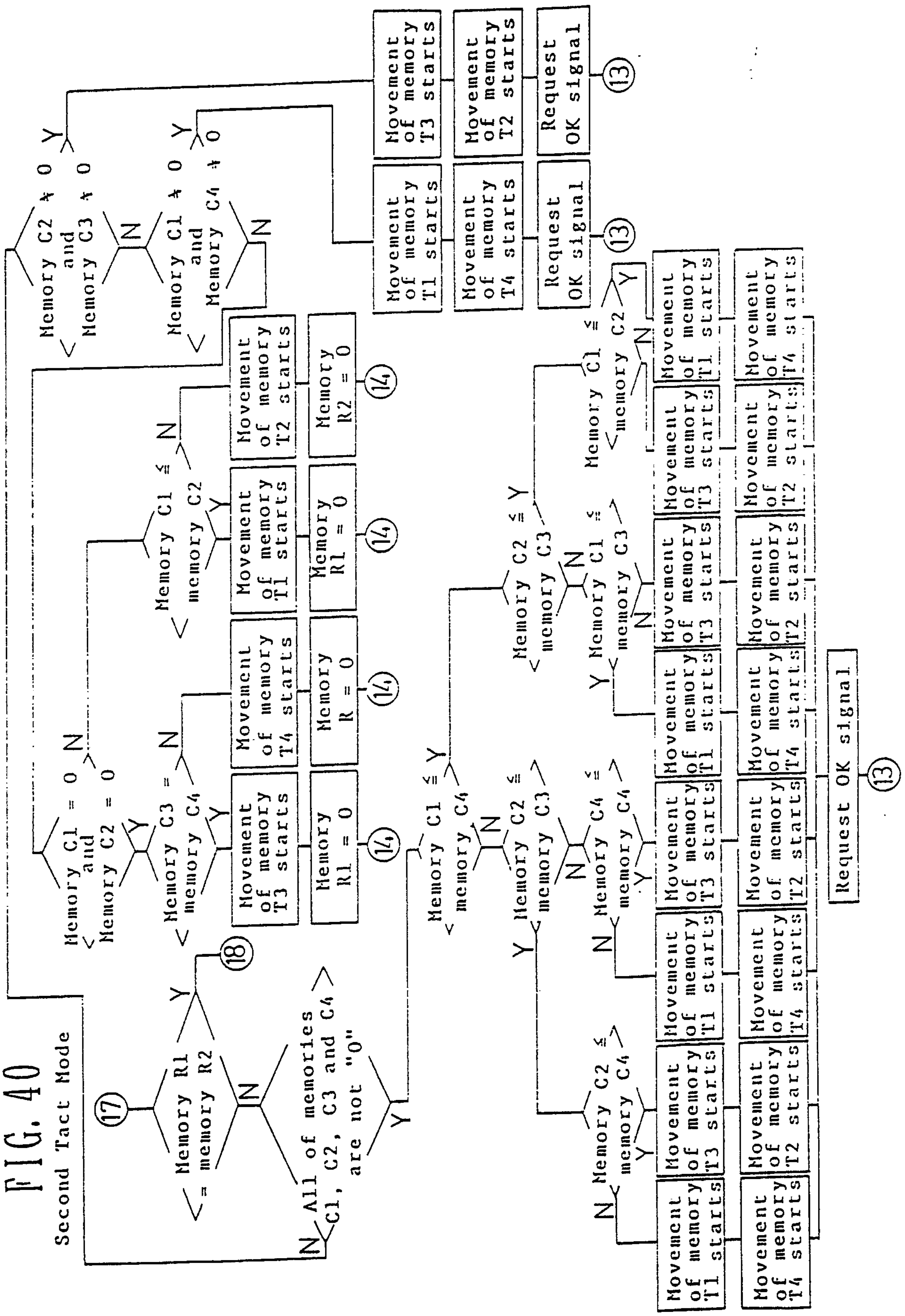


FIG. 40

Second Tact Mode

FIG. 41

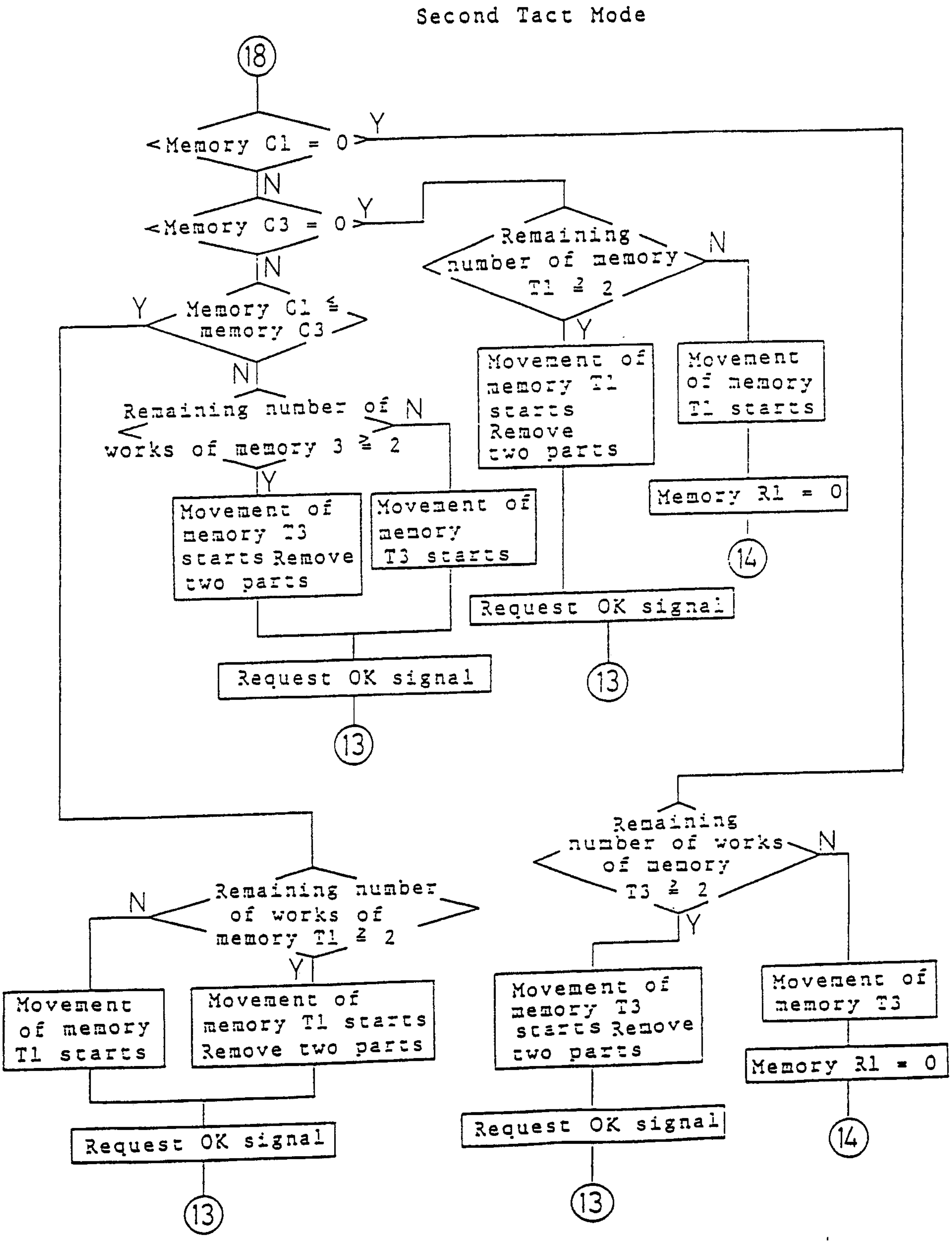
Second Tact Mode
18
Memory C1 = 0
Y
N
Memory C3 = 0
Y
N
Memory C1 ≦ memory C3
Y
N
Remaining number of works of memory 3 ≧ 2
N
Y
Movement of memory T3 starts Remove two parts
Movement of memory T3 starts
Request OK signal
13
Remaining number of memory T1 ≧ 2
N
Y
Movement of memory T1 starts Remove two parts
Movement of memory T1 starts
Memory R1 = 0
14
Request OK signal
13
Remaining number of works of memory T1 ≧ 2
N
Y
Movement of memory T1 starts
Movement of memory T1 starts Remove two parts
Request OK signal
13
Remaining number of works of memory T3 ≧ 2
N
Y
Movement of memory T3 starts Remove two parts
Movement of memory T3
Memory R1 = 0
Request OK signal
13
14

European Patent Office

# EUROPEAN SEARCH REPORT

Application number

EP 90110365.5

## DOCUMENTS CONSIDERED TO BE RELEVANT

| Category | Citation of document with indication, where appropriate, of relevant passages | Relevant to claim | CLASSIFICATION OF THE APPLICATION (Int Cl⁵) |
|---|---|---|---|
| D,A | US - A - 4 747 198 (ASAI) * Abstract; fig. 1-10 * -- | 1-8 | H 05 K 13/04 |
| D,A | US - A - 4 653 664 (HINERO) * Abstract; fig. 1-15 * -- | 1-8 | |
| D,A | JP - A -61-280 700 * Fig. 1-3 * -- | 1-8 | |
| A | EP - A2 - 0 293 148 (EMHART IND.) * Abstract; fig. 1-3 * -- | 1-8 | |
| A | EP - A2 - 0 312 116 (SANYO) * Abstract; fig. 1-4 * -- | 1-8 | TECHNICAL FIELDS SEARCHED (Int Cl⁵) |
| A | US - A - 3 893 232 (FLETCHER) * Abstract; fig. 1 * -- | 1-8 | H 05 K 13/00 |
| A | US - A - 4 293 998 (KAWA) * Abstract; fig. 1-14 * ---- | 1-8 | |

The present search report has been drawn up for all claims

| Place of search | Date of completion of the search | Examiner |
|---|---|---|
| VIENNA | 27-08-1990 | VAKIL |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82